# EUROPEAN PATENT APPLICATION

(11) **EP 1 696 478 A1**
(43) Date of publication of application: **30.08.2006**
(21) Application number: 04807107.0
(22) Date of filing: 15.12.2004
(51) Int. Cl.: H01L 21/312, H01L 21/768

(54) **INSULATING FILM, METHOD FOR FORMING SAME AND COMPOSITION FOR FORMING FILM**

(30) Priority: 19.12.2003 JP 2003423047
(71) Applicant: JSR Corporation, Tokyo 104-8410 (JP)
(72) Inventor: SHIOTA, Atsushi, Chuo-ku, Tokyo 1048410 (JP)
(74) Representative: TBK-Patent
(86) International application number: PCT/JP2004/018748
(87) International publication number: WO 2005/059987

(57) **Abstract**

The invention provides a method of forming an insulating film which exhibits resistance against processing such as RIE used when forming a dual-damascene structure while maintaining a low relative dielectric constant of a polysiloxane insulating film. A polysiloxane insulating film is formed on a substrate by hydrolysis and condensation of a silane compound. A solution obtained by dissolving a polycarbosilane compound shown by the following general formula in a solvent is applied to the polysiloxane insulating film, and the resulting coating is heated to form a polycarbosilane insulating film. 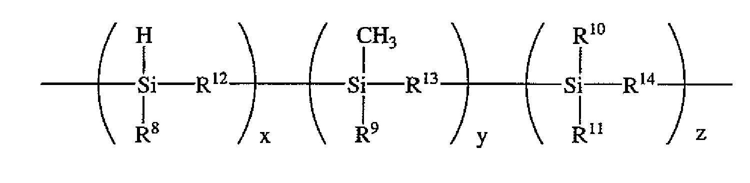 An organic insulating film is then formed on the polycarbosilane insulating film.

## Description

### TECHNICAL FIELD

The present invention relates to a method of forming an insulating film. More particularly, the invention relates to an insulating film suitably used as an interlayer dielectric for a semiconductor device or the like, a method of forming the same, and a film-forming composition.

### BACKGROUND ART

A silica (SiO₂) film formed by a vacuum process such as a chemical vapor deposition (CVD) method has been widely used as an interlayer dielectric for a semiconductor device or the like. In recent years, in order to form an interlayer dielectric having a more uniform thickness, a spin-on-glass (SOG) film, which is a coating-type insulating film containing a tetraalkoxysilane hydrolysate as the major component, has also been used. Along with an increase in the degree of integration of a semiconductor device, a low-relative-dielectric-constant interlayer dielectric called an organic SOG containing a polyorganopolysiloxane as the major component has been developed.

However, accompanying a further increase in the degree of integration and multilayering of a semiconductor device, more excellent electrical insulation between conductors has been demanded. Therefore, an interlayer dielectric having excellent storage stability and a lower relative dielectric constant (low-k) and exhibiting superior leakage current characteristics has been in demand.

In the case of forming interconnects having a dual-damascene structure when forming an interconnect layer of a semiconductor device, a low-k insulating film represented by a polysiloxane insulating film may be formed as a layer in which a via is formed, and an organic insulating film, which is also a low-k insulating film, may be formed as a layer in which a trench is formed. When forming the trench in the organic insulating film, reactive ion etching (RIE) is performed by using a gas such as ammonia or H₂/N₂. In this case, damage due to etching may occur in the polysiloxane insulating film formed under the organic insulating film. If the insulating film is damaged, the relative dielectric constant of the insulating film is increased, or the insulating film exhibits decreased resistance against processing such as etching, ashing, or wet cleaning. This may cause the characteristics of the interconnects to deteriorate, whereby the reliability of the semiconductor device may be impaired.

### DISCLOSURE OF THE INVENTION

An objective of the invention is to provide a method of forming an insulating film capable of forming an insulating film which may be suitably used for a semiconductor device, for which an increase in the degree of integration and multilayering has been demanded, has a low relative dielectric constant, and exhibits excellent resistance against processing such as etching, ashing, or wet cleaning, and an insulating film formed by using the method.

Another objective of the invention is to provide a film-forming composition which may be suitably used for the method of forming an insulating film.

A method of forming an insulating film according to the invention comprises:
forming a polysiloxane insulating film on a substrate;
forming a polycarbosilane insulating film on the polysiloxane insulating film; and
forming an organic insulating film on the polycarbosilane insulating film;
wherein the polysiloxane insulating film is formed by hydrolysis and condensation of at least one silane compound selected from the group consisting of compounds shown by the following general formulas (1) to (3),

RₐSi(OR¹)₄₋ₐ (1)

wherein R represents a hydrogen atom, a fluorine atom, or a monovalent organic group, R¹ represents a monovalent organic group, and a represents an integer of 1 or 2,

Si(OR²)₄ (2)

wherein R² represents a monovalent organic group,

R³_{b}(R⁴O)_{3-b}Si-(R⁷)_{d}-Si(OR⁵)_{3-c}R⁶_{c} (3)

wherein R³ to R⁶ individually represent monovalent organic groups, b and c individually represent an integer from 0 to 2, R⁷ represents an oxygen atom, a phenylene group, or a group -(CH₂)ₘ- (wherein m represents an integer from 1 to 6), and d represents 0 or 1; and
wherein the polycarbosilane insulating film is formed by applying a solution, obtained by dissolving a polycarbosilane compound shown by the following general formula (4) in a solvent, to the polysiloxane insulating film, and heating the resulting coating, 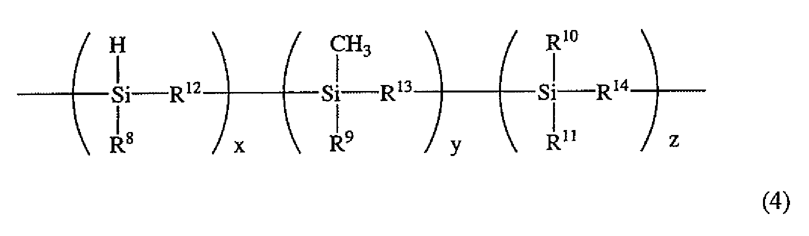 wherein R⁸ to R¹¹ individually represent a hydrogen atom, a halogen atom, a hydroxyl group, alkoxyl group, sulfone group, methanesulfone group, trifluoromethanesulfone group, or monovalent organic group, R¹² to R¹⁴ individually represent a substituted or unsubstituted alkylene group, alkenyl group, alkynyl group, or arylene group, and x, y, and z represent integers from 0 to 10,000, provided that x, y, and z satisfy a condition of "10 < x+y+z < 20,000".

An insulating film according to the invention comprises:
a polysiloxane insulating film formed on a substrate;
a polycarbosilane insulating film formed on the polysiloxane insulating film; and
an organic insulating film on the polycarbosilane insulating film;
wherein the polysiloxane insulating film is formed by hydrolysis and condensation of at least one silane compound selected from the group consisting of compounds shown by the following general formulas (1) to (3),

RₐSi(OR¹)₄₋ₐ (1)

wherein R represents a hydrogen atom, a fluorine atom, or a monovalent organic group, R¹ represents a monovalent organic group, and a represents an integer of 1 or 2,

Si(OR²)₄ (2)

wherein R² represents a monovalent organic group,

R³_{b}(R⁴O)_{3-b}Si-(R⁷)_{d}-Si(OR⁵)_{3-c}R⁶_{c} (3)

wherein R³ to R⁶ individually represent monovalent organic groups, b and c individually represent an integer from 0 to 2, R⁷ represents an oxygen atom, a phenylene group, or a group -(CH₂)ₘ- (wherein m represents an integer from 1 to 6), and d represents 0 or 1; and
wherein the polycarbosilane insulating film is formed by applying a solution, obtained by dissolving a polycarbosilane compound shown by the following general formula (4) in a solvent, to the polysiloxane insulating film, and heating the resulting coating, 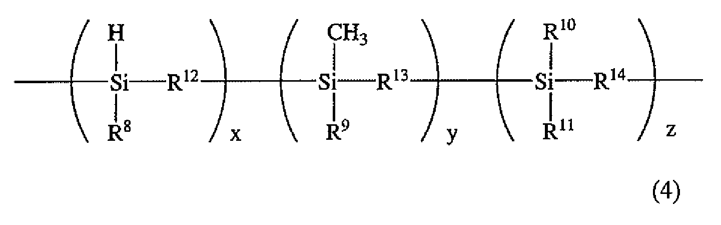 wherein R⁸ to R¹¹ individually represent a hydrogen atom, a halogen atom, a hydroxyl group, alkoxyl group, sulfone group, methanesulfone group, trifluoromethanesulfone group, or monovalent organic group, R¹² to R¹⁴ individually represent a substituted or unsubstituted alkylene group, alkenyl group, alkynyl group, or arylene group, and x, y, and z represent integers from 0 to 10,000, provided that x, y, and z satisfy a condition of "10 < x+y+z < 20,000".

A film-forming composition of the invention is for forming a polycarbosilane insulating film used in the method of forming an insulating film, and comprises:
a solution prepared by dissolving a polycarbosilane compound shown by the following general formula (4) in a solvent, 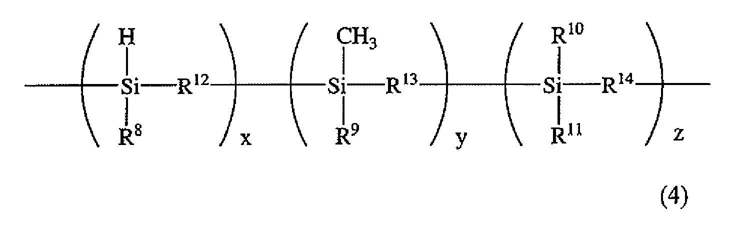
wherein R⁸ to R¹¹ individually represent a hydrogen atom, a halogen atom, a hydroxyl group, alkoxyl group, sulfone group, methanesulfone group, trifluoromethanesulfone group, or monovalent organic group, R¹² to R¹⁴ individually represent a substituted or unsubstituted alkylene group, alkenyl group, alkynyl group, or arylene group, and x, y, and z represent integers from 0 to 10,000, provided that x, y, and z satisfy a condition of "10 < x+y+z < 20,000".

According to the method of forming an insulating film according to the invention, since the polycarbosilane insulating film is formed after forming the polysiloxane insulating film (low-k film), the polysiloxane insulating film is not directly affected by etching when subjecting the organic insulating film to RIE. Therefore, the polysiloxane insulating film is not damaged. The polycarbosilane insulating film provided between the polysiloxane insulating film and the organic insulating film is rarely damaged even when exposed to plasma so that the insulating properties and mechanical strength are affected to only a small extent.

Therefore, according to the method of forming an insulating film according to the invention, an insulating film which exhibits resistance against processing such as RIE used when forming a dual-damascene structure can be formed while maintaining the low relative dielectric constant of the polysiloxane insulating film. As a result, a highly reliable interconnect layer can be formed. It suffices that the insulating film according to the invention include the polysiloxane insulating film, the polycarbosilane insulating film, and the organic insulating film. The insulating film of the invention may further include other insulating films.

Since the insulating film according to the invention has a low relative dielectric constant and exhibits excellent process resistance, the insulating film according to the invention may be suitably used as an interlayer dielectric for a semiconductor device. In particular, the insulating film according to the invention may also be suitably used when forming an interconnect layer having a dual-damascene structure.

The method of forming an insulating film, the insulating film, and the film-forming composition according to the invention are described below in more detail.

The method of forming an insulating film according to the invention includes forming a polysiloxane insulating film on a substrate, forming a polycarbosilane insulating film on the polysiloxane insulating film, and forming an organic insulating film on the polycarbosilane insulating film. The "coating" used in the invention means a film obtained by applying a film-forming composition to a substrate and removing an organic solvent.

### 1. Method of forming polysiloxane insulating film

### 1.1. Component for forming polysiloxane insulating film (component (A))

In the method of forming an insulating film of the invention, the component (A) is a polysiloxane compound obtained by hydrolysis and condensation of at least one silane compound selected from the group consisting of compounds shown by the following formula (1) (hereinafter called "compound 1"), compounds shown by the following formula (2) (hereinafter called "compound 2"), and compounds shown by the following formula (3) (hereinafter called "compound 3"). In the following description, the component (A) also includes the polysiloxane compound dissolved or dispersed in an organic solvent.

RₐSi(OR¹)₄₋ₐ (1)

wherein R represents a hydrogen atom, a fluorine atom, or a monovalent organic group, R¹ represents a monovalent organic group, and a represents 1 or 2.

Si(OR²)₄ (2)

wherein R² represents a monovalent organic group.

R³_{b}(R⁴O)_{3-b}Si-(R⁷)_{d}-Si(OR⁵)_{3-c}R⁶_{c} (3)

wherein R³ to R⁶ individually represent monovalent organic groups, b and c individually represent integers from 0 to 2, R⁷ represents an oxygen atom, a phenylene group, or a group -(CH₂)ₘ- (wherein m represents an integer from 1 to 6), and d represents 0 or 1.

### 1.1.1 Compound 1

In the general formula (1), as the monovalent organic group represented by R and R¹, an alkyl group, aryl group, allyl group, glycidyl group, and the like can be given. It is preferable that the monovalent organic group represented by R¹ in the general formula (1) be an alkyl group or a phenyl group. As examples of the alkyl group, a methyl group, an ethyl group, a propyl group, a butyl group, and the like can be given. The alkyl group preferably includes 1 to 5 carbon atoms. The alkyl group may be either linear or branched. A hydrogen atom in the alkyl group may be replaced by a fluorine atom or the like. As examples of the aryl group in the general formula (1), a phenyl group, a naphthyl group, a methylphenyl group, an ethylphenyl group, a chlorophenyl group, a bromophenyl group, a fluorophenyl group, and the like can be given.

As specific examples of the compound 1, methyltrimethoxysilane, methyltriethoxysilane, methyltri-n-propoxysilane, methyltriisopropoxysilane, methyltri-n-butoxysilane, methyltri-sec-butoxysilane, methyltri-tert-butoxysilane, methyltriphenoxysilane, ethyltrimethoxysilane, ethyltriethoxysilane, ethyltri-n-propoxysilane, ethyltriisopropoxysilane, ethyltri-n-butoxysilane, ethyltri-sec-butoxysilane, ethyltri-tert-butoxysilane, ethyltriphenoxysilane, n-propyltrimethoxysilane, n-propyltriethoxysilane, n-propyltri-n-propoxysilane, n-propyltriisopropoxysilane, n-propyltri-n-butoxysilane, n-propyltri-sec-butoxysilane, n-propyltri-tert-butoxysilane, n-propyltriphenoxysilane, isopropyltrimethoxysilane, isopropyltriethoxysilane, isopropyltri-n-propoxysilane, isopropyltriisopropoxysilane, isopropyltri-n-butoxysilane, isopropyltri-sec-butoxysilane, isopropyltri-tert-butoxysilane, isopropyltriphenoxysilane, n-butyltrimethoxysilane, n-butyltriethoxysilane, n-butyltri-n-propoxysilane, n-butyltriisopropoxysilane, n-butyltri-n-butoxysilane, n-butyltri-sec-butoxysilane, n-butyltri-tert-butoxysilane, n-butyltriphenoxysilane, sec-butyltrimethoxysilane, sec-butylisotriethoxysilane, sec-butyltri-n-propoxysilane, sec-butyltriisopropoxysilane, sec-butyltri-n-butoxysilane, sec-butyltri-sec-butoxysilane, sec-butyltri-tert-butoxysilane, sec-butyltriphenoxysilane, tert-butyltrimethoxysilane, tert-butyltriethoxysilane, tert-butyltri-n-propoxysilane, tert-butyltriisopropoxysilane, tert-butyltri-n-butoxysilane, tert-butyltri-sec-butoxysilane, tert-butyltri-tert-butoxysilane, tert-butyltriphenoxysilane, phenyltrimethoxysilane, phenyltriethoxysilane, phenyltri-n-propoxysilane, phenyltriisopropoxysilane, phenyltri-n-butoxysilane, phenyltri-sec-butoxysilane, phenyltri-tert-butoxysilane, phenyltriphenoxysilane, dimethyldimethoxysilane, dimethyldiethoxysilane, dimethyldi-n-propoxysilane, dimethyldiisopropoxysilane, dimethyldi-n-butoxysilane, dimethyldi-sec-butoxysilane, dimethyldi-tert-butoxysilane, dimethyldiphenoxysilane, diethyldimethoxysilane, diethyldiethoxysilane, diethyldi-n-propoxysilane, diethyldiisopropoxysilane, diethytdi-n-butoxysitane, diethyldi-sec-butoxysilane, diethyldi-tert-butoxysilane, diethyldiphenoxysilane, di-n-propyldimethoxysilane, di-n-propyldiethoxysilane, di-n-propyldi-n-propoxysilane, di-n-propyldiisopropoxysilane, di-n-propyldi-n-butoxysilane, di-n-propyldi-sec-butoxysilane, di-n-propyldi-tert-butoxysilane, di-n-propyl-diphenoxysilane, diisopropyldimethoxysilane, diisopropyldiethoxysilane, diisopropyldi-n-propoxysilane, diisopropyldiisopropoxysilane, diisopropyldi-n-butoxysilane, diisopropyldi-sec-butoxysilane, diisopropyldi-tert-butoxysilane, diisopropyldiphenoxysilane, di-n-butyldimethoxysilane, di-n-butyldiethoxysilane, di-n-butyldi-n-propoxysilane, di-n-butyldiisopropoxysilane, di-n-butyldi-n-butoxysilane, di-n-butyldi-sec-butoxysilane, di-n-butyldi-tert-butoxysilane, di-n-butyldiphenoxysilane, di-sec-butyldimethoxysilane, di-sec-butyldiethoxysilane, di-sec-butyldi-n-propoxysilane, di-sec-butyldiisopropoxysilane, di-sec-butyldi-n-butoxysilane, di-sec-buiyldi-sec-butoxysilane, di-sec-butyldi-tert-butoxysilane, di-sec-butyl-diphenoxysilane, di-tert-butyldimethoxysilane, di-tert-butyldiethoxysilane, di-tert-butyldi-n-propoxysilane, di-tert-butyldiisopropoxysilane, di-tert-butyldi-n-butoxysilane, di-tert-butyldi-sec-butoxysilane, di-tert-butyldi-tert-butoxysilane, di-tert-butyl-diphenoxysilane, diphenyldimethoxysilane, diphenyldiethoxysilane, diphenyldi-n-propoxysilane, diphenyldiisapropoxysilane, diphenyldi-n-butoxysilane, diphenyldi-sec-butoxysilane, diphenyldi-tert-butoxysilane, diphenyldiphenoxysilane, divinyltrimethoxysilane, γ-aminopropyltrimethoxysilane, γ-aminopropyltriethoxysilane, γ-glycidoxypropyltrimethoxysilane, γ-glycidoxypropyltriethoxysilane, γ-trifluoropropyltrimethoxysilane, γ-trifluoropropyltriethoxysilane, and the like can be given. These compounds may be used either individually or in combination of two or more.

Of these, tetramethoxysilane, tetraethoxysilane, tetra-n-propoxysilane, tetraisopropoxysilane, tetraphenoxysilane, methyltrimethoxysilane, methyltriethoxysilane, methyltri-n-propoxysilane, methyltriisopropoxysilane, ethyltrimethoxysilane, ethyltriethoxysilane, vinyltrimethoxysilane, vinyltriethoxysilane, phenyltrimethoxysilane, phenyltriethoxysilane, dimethyldimethoxysilane, dimethyldiethoxysilane, diethyldimethoxysilane, diethyldiethoxysilane, diphenyldimethoxysilane, diphenyldiethoxysilane, tetramethoxysilane, tetramethoxysilane, tetraethoxysilane, tetra-n-propoxysilane, tetraisopropoxysilane, tetra-n-butoxysilane, tetra-sec-butoxysilane, tetra-tert-butoxysilane, tetraphenoxysilane, and the like are particularly preferable as the compound 1.

### 1.1.2 Compound 2

In the general formula (2), as examples of the monovalent organic group represented by R², the organic groups given as examples for the general formula (1) can be given.

As specific examples of the compound 2, tetramethoxysilane, tetraethoxysilane, tetra-n-propoxysilane, tetraisopropoxysilane, tetra-n-butoxysilane, tetra-sec-butoxysilane, tetra-tert-butoxysilane, tetraphenoxysilane, and the like can be given. Of these, tetramethoxysilane and tetraethoxysilane are particularly preferable. These compounds may be used either individually or in combination of two or more.

### 1.1.3 Compound 3

As examples of the compounds shown by the general formula (3) in which d is 0, hexamethoxydisilane, hexaethoxydisilane, hexaphenoxydisilane, 1,1,1,2,2-pentamethoxy-2-methyldisilane, 1,1,1,2,2-pentaethoxy-2-methyldisilane, 1,1,1,2,2-pentaphenoxy-2-methyldisilane, 1,1,1,2,2-pentamethoxy-2-ethyldisilane, 1,1,1,2,2-pentaethoxy-2-ethyldisilane, 1,1,1,2,2-pentaphenoxy-2-ethyldisilane, 1,1,1,2,2-pentamethoxy-2-phenyldisilane, 1,1,1,2,2-pentaethoxy-2-phenyldisilane, 1,1,1,2,2-pentaphenoxy-2-phenyldisilane, 1,1,2,2-tetramethoxy-1,2-dimethyldisilane, 1,1,2,2-tetraethoxy-1,2-dimethyldisilane, 1,1,2,2-tetraphenoxy-1,2-dimethyldisilane, 1,1,2,2-tetramethoxy-1,2-diethyldisilane, 1,1,2,2-tetraethoxy-1,2-diethyldisilane, 1,1,2,2-tetraphenoxy-1,2-diethyldisilane, 1,1,2,2-tetramethoxy-1,2-diphenyldisilane, 1,1,2,2-tetraethoxy-1,2-diphenyldisilane, 1,1,2,2-tetraphenoxy-1,2-diphenyldisilane, 1,1,2-trimethoxy-1,2,2-trimethyldisilane, 1,1,2-triethoxy-1,2,2-trimethyldisilane, 1,1,2-triphenoxy-1,2,2-trimethyldisilane, 1,1,2-trimethoxy-1,2,2-triethyldisilane, 1,1,2-triethoxy-1,2,2-triethyldisilane, 1,1,2-triphenoxy-1,2,2-triethyldisilane, 1,1,2-trimethoxy-1,2,2-triphenyldisilane, 1,1,2-triethoxy-1,2,2-triphenyldisilane, 1,1,2-triphenoxy-1,2,2-triphenyldisilane, 1,2-dimethoxy-1,1,2,2-tetramethyldisilane, 1,2-diethoxy-1,1,2,2-tetramethyldisilane, 1,2-diphenoxy-1,1,2,2-tetramethyldisilane, 1,2-dimethoxy-1,1,2,2-tetraethyldisilane, 1,2-diethoxy-1,1,2,2-tetraethyldisilane, 1,2-diphenoxy-1,1,2,2-tetraethyldisilane, 1,2-dimethoxy-1,1,2,2-tetraphenyldisilane, 1,2-diethoxy-1,1,2,2-tetraphenyldisilane, 1,2-diphenoxy-1,1,2,2-tetraphenyldisilane, and the like can be given.

Of these, hexamethoxydisilane, hexaethoxydisilane, 1,1,2,2-tetramethoxy-1,2-dimethyldisilane, 1,1,2,2-tetraethoxy-1,2-dimethyldisilane, 1,1,2,2-tetramethoxy-1,2-diphenyldisilane, 1,2-dimethoxy-1,1,2,2-tetramethyldisilane, 1,2-diethoxy-1,1,2,2-tetramethyldisilane, 1,2-dimethoxy-1,1,2,2-tetraphenyldisilane, 1,2-diethoxy-1,1,2,2-tetraphenyldisilane, and the like are preferable.

As examples of the compounds shown by the general formula (3) in which R⁷ represents the group -(CH₂)ₘ-, bis(trimethoxysilyl)methane, bis(triethoxysilyl)methane, bis(tri-n-propoxysilyl)methane, bis(triisopropoxysilyl)methane, bis(tri-n-butoxysilyl)methane, bis(tri-sec-butoxysilyl)methane, bis(tri-tert-butoxysilyl)methane, 1,2-bis(trimethoxysilyl)ethane, 1,2-bis(triethoxysilyl)ethane, 1,2-bis(tri-n-propoxysilyl)ethane, 1,2-bis(triisopropoxysilyl)ethane, 1,2-bis(tri-n-butoxysilyl)ethane, 1,2-bis(tri-sec-butoxysilyi)ethane, 1,2-bis(tri-tert-butoxysilyl)ethane, 1-(dimethoxymethylsilyl)-1-(trimethoxysilyl)methane, 1-(diethoxymethylsilyl)-1-(triethoxysilyl)methane, 1-(di-n-propoxymethylsilyl)-1-(tri-n-propoxysilyl)methane, 1-(diisopropoxymethylsilyl)-1-(triisopropoxysilyl)methane, 1-(di-n-butoxymethylsilyl)-1-(tri-n-butoxysilyl)methane, 1-(di-sec-butoxymethylsilyl)-1-(tri-sec-butoxysilyl)methane, 1-(di-tert-butoxymethylsilyl)-1-(tri-tert-butoxysilyl)methane, 1-(dimethoxymethylsilyl)-2-(trimethoxysilyl)ethane, 1-(diethoxymethylsilyl)-2-(triethoxysilyl)ethane, 1-(di-n-propoxymethylsilyl)-2-(tri-n-propoxysilyl)ethane, 1-(diisopropoxymethylsilyl)-2-(triisopropoxysilyl)ethane, 1-(di-n-butoxymethylsilyl)-2-(tri-n-butoxysilyl)ethane, 1-(di-sec-butoxymethylsilyl)-2-(tri-sec-butoxysilyl)ethane, 1-(di-tert-butoxymethylsilyl)-2-(tri-tert-butoxysilyl)ethane, bis(dimethoxymethylsilyl)methane, bis(diethoxymethylsilyl)methane, bis(di-n-propoxymethylsilyl)methane, bis(diisopropoxymethylsilyl)methane, bis(di-n-butoxymethylsilyl)methane, bis(di-sec-butoxymethylsilyl)methane, bis(di-tert-butoxymethylsilyl)methane, 1,2-bis(dimethoxymethylsilyl)ethane, 1,2-bis(diethoxymethylsilyl)ethane, 1,2-bis(di-n-propoxymethylsilyl)ethane, 1,2-bis(diisopropoxymethylsilyl)ethane, 1,2-bis(di-n-butoxymethylsilyl)ethane, 1,2-bis(di-sec-butoxymethylsilyl)ethane, 1,2-bis(di-tert-butoxymethylsilyl)ethane, 1,2-bis(trimethoxysilyl)benzene, 1,2-bis(triethoxysilyl)benzene, 1,2-bis(tri-n-propoxysilyl)benzene, 1,2-bis(triisopropoxysilyl)benzene, 1,2-bis(tri-n-butoxysilyl)benzene, 1,2-bis(tri-sec-butoxysilyl)benzene, 1,2-bis(tri-tert-butoxysilyl)benzene, 1,3-bis(trimethoxysilyl)benzene, 1,3-bis(triethoxysilyl)benzene, 1,3-bis(tri-n-propoxysilyl)benzene, 1,3-bis(triisopropoxysilyl)benzene, 1,3-bis(tri-n-butoxysilyl)benzene, 1,3-bis(tri-sec-butoxysilyl)benzene, 1,3-bis(tri-tert-butoxysilyl)benzene, 1,4-bis(trimethoxysilyl)benzene, 1,4-bis(triethoxysilyl)benzene, 1,4-bis(tri-n-propoxysilyl)benzene, 1,4-bis(triisopropoxysilyl)benzene, 1,4-bis(tri-n-butoxysilyl)benzene, 1,4-bis(tri-sec-butoxysilyl)benzene, 1,4-bis(tri-tert-butoxysilyl)benzene, and the like can be given.

Of these, bis(trimethoxysilyl)methane, bis(triethoxysilyl)methane, 1,2-bis(trimethoxysilyl)ethane, 1,2-bis(triethoxysilyl)ethane, 1-(dimethoxymethylsilyl)-1-(trimethoxysilyl)methane, 1-(diethoxymethylsilyl)-1-(triethoxysilyl)methane, 1-(dimethoxymethylsilyl)-2-(trimethoxysilyl)ethane, 1-(diethoxymethylsilyl)-2-(triethoxysilyl)ethane, bis(dimethoxymethylsllyl)methane, bis(diethoxymethylsilyl)methane, 1,2-bis(dimethoxymethylsilyl)ethane, 1,2-bis(diethoxymethylsilyl)ethane, 1,2-bis(trimethoxysilyl)benzene, 1,2-bis(triethoxysilyl)benzene, 1,3-bis(trimethoxysilyl)benzene, 1,3-bis(triethoxysilyl)benzene, 1,4-bis(trimethoxysilyl)benzene, 1,4-bis(triethoxysilyl)benzene, and the like are preferable.

The compounds 1 to 3 may be used either individually or in combination of two or more.

When subjecting the compounds 1 to 3 to hydrolysis and partial condensation, it is preferable to use water in an amount of 0.3 to 10 mol for one mol of the groups represented by R¹O-, R²O-, R⁴O-, and R⁵O- in the general formulas (1) to (3). When the siloxane compound is a condensation product, the siloxane compound preferably has a polystyrene-reduced weight average molecular weight of 500 to 10,000. A complete hydrolysis-condensation product used in the invention refers to a product in which the groups represented by R¹O-, R²O-, R⁴O-, and R⁵O- in the siloxane compound are entirely hydrolyzed to form OH groups and the resulting silanol groups are completely condensed.

### 1.1.4. Catalyst

In the method of forming an insulating film of the invention, a catalyst may be contained in the component (A), if necessary. As examples of the catalyst, an organic acid, an inorganic acid, an organic base, an inorganic base, a metal chelate, and the like can be given.

As examples of the organic acid, acetic acid, propionic acid, butanoic acid, pentanoic acid, hexanoic acid, heptanoic acid, octanoic acid, nonanoic acid, decanoic acid, oxalic acid, maleic acid, methylmalonic acid, adipic acid, sebacic acid, gallic acid, butyric acid, mellitic acid, arachidonic acid, shikimic acid, 2-ethylhexanoic acid, oleic acid, stearic acid, linolic acid, linoleic acid, salicylic acid, benzoic acid, p-aminobenzoic acid, p-toluenesulfonic acid, benzenesulfonic acid, monochloroacetic acid, dichloroacetic acid, trichloroacetic acid, trifluoroacetic acid, formic acid, malonic acid, sulfonic acid, phthalic acid, fumaric acid, citric acid, tartaric acid, and the like can be given.

As examples of the inorganic acid, hydrochloric acid, nitric acid, sulfuric acid, hydrofluoric acid, phosphoric acid, and the like can be given. As examples of the inorganic base, ammonia, sodium hydroxide, potassium hydroxide, barium hydroxide, calcium hydroxide, and the like can be given.

As examples of the organic base, methanolamine, ethanolamine, propanolamine, butanolamine, N-methylmethanolamine, N-ethylmethanolamine, N-propyImethanolamine, N-butylmethanolamine, N-methylethanolamine, N-ethylethanolamine, N-propylethanolamine, N-butylethanolamine, N-methylpropanolamine, N-ethylpropanolamine, N-propylpropanolamine, N-butylpropanolamine, N-methylbutanolamine, N-ethylbutanolamine, N-propylbutanolamine, N-butylbutanolamine, N,N-dimethylmethanolamine, N,N-diethylmethanolamine, N,N-dipropylmethanolamine, N,N-dibutylmetanolamine, N,N-dimethylethanolamine, N,N-diethylethanolamine, N,N-dipropylethanolamine, N,N-dibutylethanolamine, N,N-dimethylpropanolamine, N,N-diethylpropanolamine, N,N-dipropylpropanolamine, N,N-dibutylpropanolamine, N,N-dimethylbutanolamine, N,N-diethylbutanolamine, N,N-dipropylbutanolamine, N,N-dibutylbutanolamine, N-methyldimethanolamine, N-ethyldimethanolamine, N-propyldimethanolamine, N-butyldimethanolamine, N-methyldiethanoleamine, N-ethyldiethanolamine, N-propyldiethanolamine, N-butyldiethanolamine, N-methyldipropanolamine, N-ethyldipropanolamine, N-propyldipropanolamine, N-butyldipropanolamine, N-methyldibutanolamine, N-ethyldibutanolamine, N-propyldibutanolamine, N-butyldibutanolamine, N-(aminomethyl)methanolamine, N-(aminomethyl)ethanolamine, N-(aminomethyl)propanolamine, N-(aminomethyl)butanolamine, N-(aminoethyl)methanolamine, N-(aminoethyl)ethanolamine, N-(aminoethyl)propanolamine, N-(aminoethyl)butanolamine, N-(aminopropyl)methanolamine, N-(aminopropyl)ethanolamine, N-(aminopropyl)propanolamine, N-(aminopropyl)butanolamine, N-(aminobutyl)methanolamine, N-(aminobutyl)ethanolamine, N-(aminobutyl)propanolamine, N-(aminobutyl)butanolamine, methoxymethylamine, methoxyethylamine, methoxypropylamine, methoxybutylamine, ethoxymethylamine, ethoxyethylamine, ethoxypropylamine, ethoxybutylamine, propoxymethylamine, propoxyethylamine, propoxypropylamine, propoxybutylamine, butoxymethylamine, butoxyethylamine, butoxypropylamine, butoxybutylamine, methylamine, ethylamine, propylamine, butylamine, N,N-dimethylamine, N,N-diethylamine, N,N-dipropylamine, N,N-dibutylamine, trimethylamine, triethylamine, tripropylamine, tributylamine, tetramethylammonium hydroxide, tetraethylammonium hydroxide, tetrapropylammonium hydroxide, tetrabutylammonium hydroxide, tetramethylethylenediamine, tetraethylethylenediamine, tetrapropylethylenediamine, tetrabutylethylenediamine, methylaminomethylamine, methylaminoethylamine, methylaminopropylamine, methylaminobutylamine, ethylaminomethylamine, ethylaminoethylamine, ethylaminopropylamine, ethylaminobutylamine, propylaminomethylamine, propylaminoethylamine, propylaminopropylamine, propylaminobutylamine, butylaminomethylamine, butylaminoethylamine, butylaminopropylamine, butylaminobutylamine, pyridine, pyrrole, piperazine, pyrrolidine, piperidine, picoline, morpholine, methylmorpholine, diazabicyclooctane, diazabicyclononane, diazabicycloundecene, and the like can be given.

As examples of the metal chelate, titanium chelate compounds such as triethoxy·mono(acetylacetonato)titanium, tri-n-propoxy·mono(acetylacetonato)titanium, triisopropoxy·mono(acetylacetonato)titanium, tri-n-butoxy·mono(acetylacetonato)titanium, tri-sec-butoxy·mono(acetylacetonato)titanium, tri-tert-butoxy·mono(acetylacetonato)titanium, diethoxy·bis(acetylacetonato)titanium, di-n-propoxy·bis(acetylacetonato)titanium, diisopropoxy·bis(acetylacetonato)titanium, di-n-butoxy·bis(acetylacetonato)titanium, di-sec-butoxy·bis(acetylacetonato)titanium, di-tert-butoxy·bis(acetylacetonato)titanium, monoethoxy·tris(acetylacetonato)titanium, mono-n-propoxy·tris(acetylacetonato)titanium, monoisopropoxy·tris(acetylacetonato)titanium, mono-n-butoxy·tris(acetylacetonato)titanium, mono-sec-butoxy·tris(acetylacetonato)titanium, mono-tert-butoxy·tris(acetylacetonato)titanium, tetrakis(acetylacetonato)titanium, triethoxy·mono(ethylacetoacetate)titanium, tri-n-propoxy·mono(ethylacetoacetate)titanium, triisopropoxy·mono(ethylacetoacetate)titanium, tri-n-butoxy·mono(ethylacetoacetate)titanium, tri-sec-butoxymono(ethylacetoacetate)titanium, tri-tert-butoxy·mono(ethylacetoacetate)titamum, diethoxy·bis(ethylacetoacetate)titanium, di-n-propoxy·bis(ethylacetoacetate)titanium, diisopropoxy·bis(ethylacetoacetate)titanium, di-n-butoxy·bis(ethylacetoacetate)titanium, di-sec-butoxy·bis(ethylacetoacetate)titanium, di-tert-butoxy·bis(ethylacetoacetate)titanium, monoethoxy·tris(ethylacetoacetate)titanium, mono-n-propoxy·tris(ethylacetoacetate)titanium, monoisopropoxy·tris(ethylacetoacetate)titanium, mono-n-butoxy·tris(efhylacetoacetate)titanium, mono-sec-butoxy·tris(ethylacetoacetate)titanium, mono-tert-butoxy·tris(ethylacetoacetate)titanium, tetrakis(ethylacetoacetate)titanium, mono(acetylacetonato)tris(ethytacetoacetate)titanium, bis(acetylacetonato)bis(ethylacetoacetate)titanium, and tris(acetylacetonato)mono(ethylacetoacetate)titanium; zirconium chelate compounds such as triethoxymono(acetylacetonato)zirconium, tri-n-propoxy·mono(acetylacetonato)zirconium, triisopropoxy·mono(acetylacetonato)zirconium, tri-n-butoxy·mono(acetylacetonato)zirconium, tri-sec-butoxy·mono(acetylacetonato)zirconium, tri-tert-butoxy·mono(acetylacetonato)zirconium, diethoxy·bis(acetylacetonato)zirconium, di-n-propoxy-bis(acetytacetonato)zirconium, diisopropoxy·bis(acetylacetonato)zirconium, di-n-butoxy·bis(acetylacetonato)zirconium, di-sec-butoxy·bis(acetylacetonato)zirconium, di-tert-butoxy·bis(acetylacetonato)zirconium, monoethoxy·tris(acetylacetonato)zirconium, mono-n-propoxy·tris(acetylacetonato)zirconium, monoisopropoxy·tris(acetylacetonato)zirconium, mono-n-butoxy·tris(acetylacetonato)zirconium, mono-sec-butoxy·tris(acetylacetonato)zirconium, mono-tert-butoxy·tris(acetylacetonato)zirconium, tetrakis(acetylacetonato)zirconium, triethoxymono(ethylacetoacetate)zirconium, tri-n-propoxy·mono(ethylacetoacetate)zirconium, triisopropoxy·mono(ethylacetoacetate)zirconium, tri-n-butoxy·mono(ethylacetoacetate)zirconium, tri-sec-butoxy·mono(ethylacetoacetate)zirconium, tri-tert-butoxy·mono(ethylacetoacetate)zirconium, diethoxy·bis(ethylacetoacetate)zirconium, di-n-propoxy·bis(ethylacetoacetate)zirconium, diisopropoxy·bis(ethylacetoacetate)zirconium, di-n-butoxybts(ethylacetoacetate)zirconium, di-sec-butoxy·bis(ethylacetoacetate)zirconium, di-tert-butoxy·bis(ethylacetoacetate)zirconium, monoethoxy·tris(ethylacetoacetate)zirconium, mono-n-propoxy·tris(ethylacetoacetate)zirconium, monoisopropoxy·tris(ethylacetoacetate)zirconium, mono-n-butoxy·tris(ethylacetoacetate)zirconium, mono-sec-butoxy·tris(ethylacetoacetate)zirconium, mono-tert-butoxy·tris(ethylacetoacetate)zirconium, tetrakis(ethylacetoacetate)zirconium, mono(acetylacetonato)tris(ethylacetoacetate)zirconium, bis(acetylacetonato)bis(ethylacetoacetate)zirconium, and tris(acetylacetonato)mono(ethylacetoacetate)zirconium; aluminum chelate compounds such as tris(acetylacetonato)aluminum and tris(ethylacetoacetate)aluminum; and the like can be given.

The catalyst is used in an amount of usually 0.0001 to 1 mol, and preferably 0.001 to 0.1 mol for one mol of the total amount of the compounds 1 to 3.

### 1.2 Method of producing film-forming composition

In the method of producing a film-forming composition for forming the polysiloxane insulating film (hereinafter may be called "composition 1"), at least one silane compound selected from the compounds 1 to 3 is subjected to hydrolysis and condensation in the presence of the above-mentioned catalyst, water, and an organic solvent described later.

The hydrolysis and condensation is carried out usually at 20 to 180°C for 10 min to 48 hours, and preferably at 30 to 150°C for 10 min to 24 hours. The reaction is carried out in an open vessel or an airtight vessel usually at a pressure of about 0.05 to 3 MPa.

The total solid content of the composition 1 thus obtained may be appropriately adjusted according to the application, preferably in the range of 0.5 to 30 wt%. If the total solid content of the film-forming composition of the invention is 0.5 to 30 wt%, the resulting insulating film has a thickness within an appropriate range, and the composition exhibits a more excellent storage stability. The total solid content may be adjusted by concentration and dilution with an organic solvent, if necessary.

In the method of producing the composition 1, it is preferable to adjust the pH of the resulting composition to 7 or lower.

As the method for adjusting the pH, the following methods (I) to (V) can be given.
(I) Method of adding pH adjusting agent
(II) Method of evaporating tetraalkylammonium hydroxide from the composition under normal pressure or reduced pressure
(III) Method of removing tetraalkylammonium hydroxide from the composition by bubbling gas such as nitrogen or argon through the composition
(IV) Method of removing tetraalkylammonium hydroxide from the composition using ion-exchange resin
(V) Method of removing tetraalkylammonium hydroxide from the system by extraction or washing

These methods may be used in combination.

As the pH adjusting agent which may be used in the method (I), an inorganic acid and an organic acid can be given.

As examples of the inorganic acid, hydrochloric acid, nitric acid, sulfuric acid, hydrofluoric acid, phosphoric acid, boric acid, oxalic acid, and the like can be given.

As examples of the organic acid, acetic acid, propionic acid, butanoic acid, pentanoic acid, hexanoic acid, heptanoic acid, octanoic acid, nonanoic acid, decanoic acid, oxalic acid, maleic acid, methylmalonic acid, adipic acid, sebacic acid, gallic acid, butyric acid, mellitic acid, arachidonic acid, shikimic acid, 2-ethylhexanoic acid, oleic acid, stearic acid, linolic acid, linoleic acid, salicylic acid, benzoic acid, p-aminobenzoic acid, p-toluenesulfonic acid, benzenesulfonic acid, monochloroacetic acid, dichloroacetic acid, trichloroacetic acid, trifluoroacetic acid, formic acid, malonic acid, sulfonic acid, phthalic acid, fumaric acid, citric acid, tartaric acid, succinic acid, itaconic acid, mesaconic acid, citraconic acid, malic acid, hydrolysate of glutaric acid, hydrolysate of maleic anhydride, hydrolysate of phthalic anhydride, and the like can be given.

These compounds may be used either individually or in combination of two or more.

The pH of the film-forming composition is adjusted to 7 or lower, and preferably 1 to 6. The storage stability of the resulting composition is improved by adjusting the pH within the above range using the pH adjusting agent.

The pH adjusting agent is used in such an amount that the pH of the composition falls within the above range. The amount of the pH adjusting agent to be used is appropriately selected.

### 1.2.1 Organic solvent

The hydrolysis and condensation may be carried out in the presence of an organic solvent.

As the organic solvent, at least one solvent selected from the group consisting of alcohol solvents, ketone solvents, amide solvents, ester solvents, and nonprotonic solvents can be given.

Examples of the alcohol solvents include: monohydric alcohol solvents such as methanol, ethanol, n-propanol, isopropanol, n-butanol, isobutanol, sec-butanol, t-butanol, n-pentanol, isopentanol, 2-methylbutanol, sec-pentanol, t-pentanol, 3-methoxybutanol, n-hexanol, 2-methylpentanol, sec-hexanol, 2-ethylbutanol, sec-heptanol, heptanol-3, n-octanol, 2-ethylhexanol, sec-octanol, 1-nonanol, 2,6-dimethyl-heptanol-4, n-decanol, 2-undecanol, trimethylnonanol, 2-tetradecanol, 2-heptadecanol, phenol, cyclohexanol, methylcyclohexanol, 3,3,5-trimethylcyclohexanol, benzyl alcohol, and diacetone alcohol; polyhydric alcohol solvents such as ethylene glycol, 1,2-propylene glycol, 1,3-butylene glycol, pentanediol-2,4, 2-methyl-pentanediol-2,4, hexanediol-2,5, heptanediol-2,4, 2-ethyl-1,3-hexanediol, diethylene glycol, dipropylene glycol, triethylene glycol, and tripropylene glycol; polyhydric alcohol partial ether solvents such as ethylene glycol monomethyl ether, ethylene glycol monoethyl ether, ethylene glycol monopropyl ether, ethylene glycol monobutyl ether, ethylene glycol monohexyl ether, ethylene glycol monophenyl ether, ethylene glycol mono-2-ethylbutyl ether, diethylene glycol monomethyl ether, diethylene glycol monoethyl ether, diethylene glycol monopropyl ether, diethylene glycol monobutyl ether, diethylene glycol monohexyl ether, propylene glycol monomethyl ether, propylene glycol monoethyl ether, propylene glycol monopropyl ether, propylene glycol monobutyl ether, dipropylene glycol monomethyl ether, dipropylene glycol monoethyl ether, and dipropylene glycol monopropyl ether; and the like.

These alcohol solvents may be used either individually or in combination of two or more.

Examples of the ketone solvents include acetone, methyl ethyl ketone, methyl n-propyl ketone, methyl n-butyl ketone, diethyl ketone, methyl-isobutyl ketone, methyl n-pentyl ketone, ethyl n-butyl ketone, methyl n-hexyl ketone, diisobutyl ketone, trimethylnonanone, cyclohexanone, methyl cyclohexanone, 2,4-pentane dione, acetonyl acetone, acetophenone, and fenchone, β-diketones such as acetylacetone, 2,4-hexanedione, 2,4-heptanedione, 3,5-heptanedione, 2,4-octanedione, 3,5-octanedione, 2,4-nonanedione, 3,5-nonanedione, 5-methyl-2,4-hexanedione, 2,2,6,6-tetramethyl-3,5-heptanedione, and 1,1,1,5,5,5-hexafluoro-2,4-heptanedione, and the like.

These ketone solvents may be used either individually or in combination of two or more.

Examples of the amide solvents include formamide, N-methylformamide, N,N-dimethylformamide, N-ethylformamide, N,N-diethylformamide, acetamide, N-methylacetamide, N,N-dimethylacetamide, N-ethylacetamide, N,N-diethylacetamide, N-methylpropioneamide, N-methylpyrrolidone, N-formylmorpholine, N-formylpiperidine, N-formylpyrrolidine, N-acetylmorpholine, N-acetylpiperidine, N-acetylpyrrolidine, and the like.

These amide solvents may be used either individually or in combination of two or more.

Examples of the ester solvents include diethyl carbonate, ethylene carbonate, propylene carbonate, diethyl carbonate, methyl acetate, ethyl acetate, γ-butyrolactone, γ-valerolactone, n-propyl acetate, isopropyl acetate, n-butyl acetate, isobutyl acetate, sec-butyl acetate, n-pentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, n-nonyl acetate, methyl acetoacetate, ethyl acetoacetate, ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether acetate, propylene glycol monoethyl ether acetate, propylene glycol monopropyl ether acetate, propylene glycol monobutyl ether acetate, dipropylene glycol monomethyl ether acetate, dipropylene glycol monoethyl ether acetate, glycol diacetate, methoxy triglycol acetate, ethyl propionate, n-butyl propionate, isoamyl propionate, diethyl oxalate, di-n-butyl oxalate, methyl lactate, ethyl lactate, n-butyl lactate, n-amyl lactate, diethyl malonate, dimethyl phthalate, diethyl phthalate, and the like.

These ester solvents may be used either individually or in combination of two or more. Examples of the nonprotonic solvents include acetonitrile, dimethylsulfoxide, N,N,N',N'-tetraethylsulfonamide, hexamethylphosphoric acid triamide, N-methylmorphorone, N-methylpyrrole, N-ethylpyrrole, N-methyl-Δ3-pyrroline, N-methylpiperidine, N-ethylpiperidine, N,N-dimethylpiperazine, N-methylimidazole, N-methyl-4-piperidone, N-methyl-2-piperidone, N-methyl-2-pyrrolidone, 1,3-dimethyl-2-imidazolidinone, 1,3-dimethyltetrahydro-2(1H)-pyrimidinone, and the like.

These nonprotonic solvents may be used either individually or in combination of two or more.

Of these organic solvents, the alcohol solvents are preferable. The organic solvents may be used either individually or in combination of two or more.

### 1.3 Method of depositing polysiloxane insulating film

The polysiloxane insulating film may be formed by applying the composition 1 to a substrate, removing the solvent, and curing the resulting coating by heating. As the method for applying the composition 1 to the substrate, a spin coating method, a dipping method, a roller blade method, and a spray method can be given. A coating with a dry thickness of 0.01 to 1.5 µm is obtained by single application, and a coating with a dry thickness of 0.02 to 3 µm is obtained by double application.

The coating may be dried by heating at about 60 to 600°C for about 1 to 240 minutes, for example. As the heating method, a hot plate, oven, furnace, or the like may be used. The coating may be heated in air, in nitrogen, in argon, under vacuum, or under reduced pressure in which the oxygen concentration is controlled. The coating may also be formed by applying electron beams or ultraviolet rays. In this case, the drying time can be reduced.

### 2. Method of forming polycarbosilane insulating film

### 2.1. Component for forming polycarbosilane insulating film (component (B))

The component (B) is a polycarbosilane compound shown by the following general formula (4) (hereinafter may be called "compound 4"). In the following description, the component (B) also includes the polycarbosilane compound dissolved or dispersed in an organic solvent.

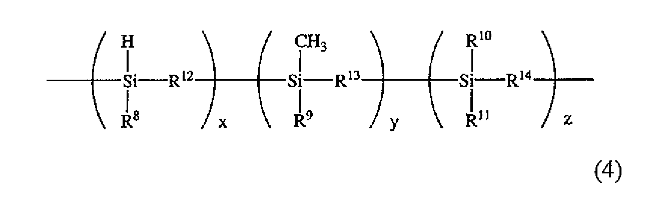

In the general formula (4), R⁸ to R¹¹ represent a hydrogen atom, a hydroxyl group, an alkoxyl group, a sulfone group, a methanesulfone group, a trifluoromethanesulfone group, or a monovalent organic group. As examples of the monovalent organic group, groups similar to the groups given as examples for the compound 1 can be given. R⁸ to R¹¹ may be either the same groups or different groups.

R¹² to R¹⁴ represent a substituted or unsubstituted alkylene group, alkenyl group, alkynyl group, or arylene group. R⁸ to R¹¹ may be either the same groups or different groups.

As examples of the alkylene group, a methylene group, ethylene group, trimethylene group, tetramethylene group, and the like can be given.

As examples of the alkenyl group, a vinylene group, a propenylene group, and the like can be given.

As examples of the alkynyl group, a ethynylene group and the like can be given.

As examples of the aryl group, a phenylene group, a naphthylene group, and the like can be given.

x, y, and z are integers from 0 to 10,000. It is preferable that x, y, and z be values which satisfy a condition of preferably "10 < x+y+z < 20,000", and still more preferably "500 < x+y+z < 10,000". Since polycarbosilane having a low molecular weight contains a large amount of volatile components, various problems may occur during deposition.

As examples of the polycarbosilane compound, polyallylhydridocarbosilane, polydimethylcarbosilane, polydimethoxycarbosilane, polymethylhydridocarbosilane, polydihydrocarbosilane, and the like can be given.

### 2.2 Method of producing film-forming composition

In the method of producing a film-forming composition for forming the polycarbosilane insulating film (hereinafter may be called "composition 2"), the film-forming composition is obtained by dissolving the compound 4 in a solvent.

The total solid content of the composition 2 thus obtained may be appropriately adjusted according to the application, preferably in the range of 0.1 to 25 wt%. If the total solid content of the composition 2 is within the above range, the resulting insulating film has a thickness within an appropriate range, and the composition exhibits a more excellent storage stability. The total solid content may be adjusted by concentration and dilution with an organic solvent, if necessary. The composition 2 is preferably prepared so that the amount of the polycarbosilane compound is 0.1 to 20 wt% and the amount of the solvent is 80 to 99.9 wt%. If the amount of the polycarbosilane compound is within this range, the resulting composition is suitable for application by using a spin coating method.

The composition 2 may include additives such as a surfactant, a pH adjusting agent, and a leveling agent, if necessary.

### 2.2.1 Organic solvent

As an organic solvent for preparing the composition 2, ketone solvents, ester solvents, alcohol solvents, aromatic solvents, and the like are given.

Examples of the ketone solvents include acetone, methyl ethyl ketone, methyl n-propyl ketone, methyl n-butyl ketone, diethyl ketone, methyl isobutyl ketone, methyl n-pentyl ketone, ethyl n-butyl ketone, methyl n-hexyl ketone, diisobutyl ketone, trimethylnonanone, cyclohexanone, methyl cyclohexanone, 2,4-pentane dione, acetonyl acetone, acetophenone, and fenchone, as well as β-diketones such as acetylacetone, 2,4-hexanedione, 2-heptanone, 2,4-heptanedione, 3,5-heptanedione, 2,4-octanedione, 3,5-octanedione, 2,4-nonanedione, 3,5-nonanedione, 5-methyl-2,4-hexanedione, 2,2,6,6-tetramethyl-3,5-heptanedione, 1,1,1,5,5,5-hexafluoro-2,4-heptanedione, and the like.

Examples of the ester solvents include diethyl carbonate, ethylene carbonate, propylene carbonate, diethyl carbonate, methyl acetate, ethyl acetate, γ-butyrolactone, γ-valerolactone, n-propyl acetate, isopropyl acetate, n-butyl acetate, isobutyl acetate, sec-butyl acetate, n-pentyl acetate, sec-pentyl acetate, 3-methoxybutyl acetate, methylpentyl acetate, 2-ethylbutyl acetate, 2-ethylhexyl acetate, benzyl acetate, cyaohexyl acetate, methylcyclohexyl acetate, n-nonyl acetate, methyl acetoacetate, ethyl acetoacetate, ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether acetate, propylene glycol monoethyl ether acetate, propylene glycol monopropyl ether acetate, propylene glycol monobutyl ether acetate, dipropylene glycol monomethyl ether acetate, dipropylene glycol monoethyl ether acetate, glycol diacetate, methoxy triglycol acetate, ethyl propionate, n-butyl propionate, isoamyl propionate, diethyl oxalate, di-n-butyl oxalate, methyl lactate, ethyl lactate, n-butyl lactate, n-amyl lactate, diethyl malonate, dimethyl phthalate, diethyl phthalate, and the like.

Examples of the alcohol solvents include polyhydric alcohol partial ether solvents such as ethylene glycol monomethyl ether, ethylene glycol monoethyl ether, ethylene glycol monopropyl ether, ethylene glycol monobutyl ether, ethylene glycol monohexyl ether, ethylene glycol monophenyl ether, ethylene glycol mono-2-ethylbutyl ether, diethylene glycol monomethyl ether, diethylene glycol monoethyl ether, diethylene glycol monopropyl ether, diethylene glycol monobutyl ether, diethylene glycol monohexyl ether, propylene glycol monomethyl ether, propylene glycol monoethyl ether, propylene glycol monopropyl ether, propylene glycol monobutyl ether, dipropylene glycol monomethyl ether, dipropylene glycol monoethyl ether, and dipropylene glycol monopropyl ether, and the like.

Examples of the aromatic solvents include benzene, toluene, xylene, mesitylene, and the like.

### 2.2.2. Surfactant

As examples of the surfactant, a nonionic surfactant, an anionic surfactant, a cationic surfactant, an amphoteric surfactant, and the like can be given. As specific examples, a fluorine-containing surfactant, a silicone surfactant, a polyalkylene oxide surfactant, a poly(meth)acrylate surfactant, and the like can be given. Of these, the fluorine-containing surfactant and the silicone surfactant are preferable.

As examples of the fluorine-containing surfactant, compounds having a fluoroalkyl or fluoroalkylene group in at least one of the terminal, main chain, and side chain, such as 1,1,2,2-tetrafluorooctyl(1,1,2,2-tetrafluoropropyl) ether, 1,1,2,2-tetrafluorooctylhexyl ether, octaethylene glycol di(1,1,2,2-tetrafluorobutyl) ether, hexaethylene glycol (1,1,2,2,3,3-hexafluoropentyl) ether, octapropylene glycol di(1,1,2,2-tetrafluorobutyl) ether, hexapropylene glycol di(1,1,2,2,3,3-hexafluoropentyl) ether, sodium perfluorododecylsulfonate, 1,1,2,2,8,8,9,9,10,10-decafluorododecane, 1,1,2,2,3,3-hexafluorodecane, N-3-(perfluorooctanesulfonamide)-propyl-N,N'-dimethyl-N-carboxymethyleneammonium betaine, perfluoroalkylsulfonamidepropyltrimethylammonium salt, perfluoroalkyl-N-ethylsulfonylglycine salt, bis(N-perfluorooctylsulfonyl-N-ethylaminoethyl)phosphate, and monoperfluoroalkylethyl phosphate can be given.

As examples of commercially available products of the fluorine-containing surfactant, Megafac F142D, F172, F173, F183 (manufactured by Dainippon Ink and Chemicals, Inc.), Eftop EF301, EF303, EF352 (manufactured by Shin-Akita Kasei Co., Ltd.). Fluorad FC-430, FC-431 (manufactured by Sumitomo 3M, Ltd.), Asahi Guard AG710, Surflon S-382, SC-101, SC-102, SC-103, SC-104, SC-105, SC-106 (manufactured by Asahi Glass Co., Ltd.), BM-1000, BM-1100 (manufactured by BM Chemie), and NBX-15 (manufactured by NEOS Co., Ltd.) can be given. Of these, Megafac F172, BM-1000, BM-1100, and NBX-15 are particularly preferable.

As the silicone surfactant, SH7PA, SH21PA, SH28PA, SH30PA, ST94PA (manufactured by Toray-Dow Corning Silicone Co., Ltd.), and the like may be used. Of these, SH28PA and SH30PA are particularly preferable.

The surfactant is used in an amount of usually 0.00001 to 1 part by weight for 100 parts by weight of the component (B).

The surfactant may be used either individually or in combination of two or more.

The composition 2 may include a leveling agent or the like in addition to the above-mentioned additives.

### 2.3 Method of forming polycarbosilane insulating film

The polycarbosilane insulating film may be formed by applying the composition 2 to the polysiloxane insulating film described in 1.3, removing the solvent, and curing the resulting coating by heating. As the method for applying the composition 2, a spin coating method, a dipping method, a roller blade method, a spray method, a scan coating method, and a slit-die coating method can be given.

The thickness of the polycarbosilane insulating film is adjusted to such an extent that the polysiloxane insulating film positioned under the polycarbosilane insulating film is not damaged by etching when etching an organic insulating film formed on the polycarbosilane insulating film by RIE, for example. The thickness (e.g. dry thickness) of the polycarbosilane insulating film is preferably 0.5 to 100 nm, and still more preferably 1 to 10 nm, taking damage to the polysiloxane insulating film into consideration. In order to form a polycarbosilane insulating film having a desired thickness, the viscosity of the composition 2 may be adjusted or the number of applications may be appropriately selected, for example.

It is preferable that heating for curing the coating be performed at a temperature suitable for the polycarbosilane compound be three-dimensionally crosslinked by polymerization. The heating is performed at preferably 60°C or higher, and still more preferably about 80 to 600°C. The heating time is not particularly limited. The heating time is usually about 1 to 240 minutes. As the method for heating the coating, a hot plate, oven, furnace, or the like may be used. The coating may be heated in air, in nitrogen, in argon, under vacuum, or under reduced pressure in which the oxygen concentration is controlled.

### 3. Method of forming organic insulating film

### 3.1 Component for forming organic insulating film

The organic insulating film of the invention is a film including at least one polymer selected from polymers having a polyarylene skeleton, a polyarylene ether skeleton, a polyoxazoline skeleton, or a polybenzocyclobutene skeleton as the major component.

As examples of these polymers, polymers including at least one repeating unit selected from repeating units shown by the following general formulas (5) to (7), (11), and (16) can be given.

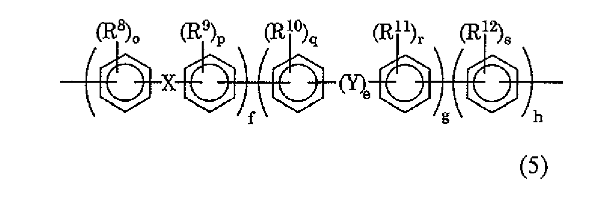

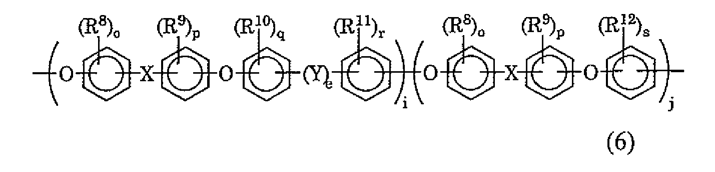

⁅C≡C―A―C≡C―B⁆ (7)

In the general formulas (5) to (7), R⁸ to R¹² individually represent a hydrocarbon group having 1 to 20 carbon atoms, a cyano group, a nitro group, an alkoxyl group having 1 to 20 carbon atoms, or a halogen atom, X represents at least one group selected from the group consisting of a group shown by -CQQ'- (wherein Q and Q' individually represent an alkyl halide group, an alkyl group, a hydrogen atom, a halogen atom, or an aryl group) and a fluorenylene group, Y represents at least one group selected from the group consisting of -O-, -CO-, -COO-, -CONH-, -S-, -SO₂- and a phenylene group, e represents 0 or 1, o to s individually represent integers from 0 to 4, f is 5 to 100 mol%, g is 0 to 95 mol%, h is 0 to 95 mol% (provided that f+g+h = 100 mol%), i is 0 to 100 mol%, j is 0 to 100 mol% (provided that i+j = 100 mol%), and A and B individually represent at least one group selected from the group consisting of divalent aromatic groups shown by the following general formulas (8) to (10).

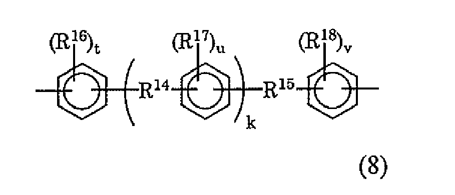

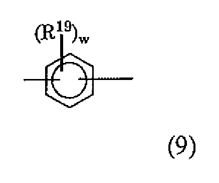

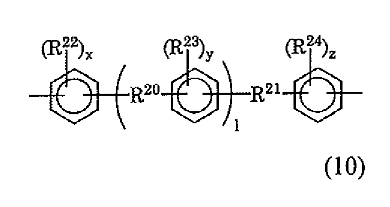

In the general formulas (8) to (10), R¹⁴, R¹⁵, R²⁰, and R²¹ individually represent a single bond, -O-, -CO-, -CH₂-, -COO-, -CONH-, -S-, -SO₂- a phenylene group, an isopropylidene group, a hexafluoroisopropylidene group, a diphenylmethylidene group, a fluorenylene group, or a group shown by the following formula, 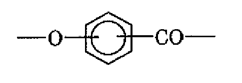 R¹⁶ to R¹⁸, R¹⁹and R²² to R²⁴ individually represent a hydrocarbon group having 1 to 20 carbon atoms, a cyano group, a nitro group, an alkoxyl group having 1 to 20 carbon atoms, or an aryl group, k represents an integer from 0 to 3, l represents an integer from 2 to 3, and t to z individually represent integers from 0 to 4.

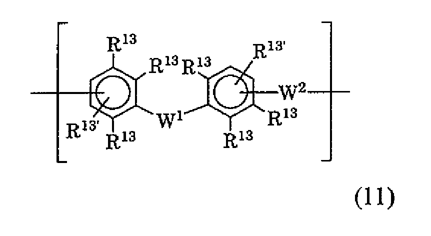

In the general formula (11), R¹³ and R^{13'} represent a hydrogen atom or at least one group selected from the group consisting of aromatic groups shown by the following general formulas (12) and (13), and W¹ and W² represent at least one group selected from the group consisting of divalent aromatic groups shown by the following general formulas (14) and (15).

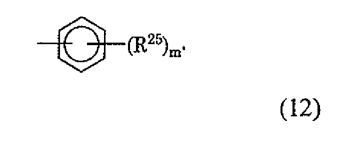

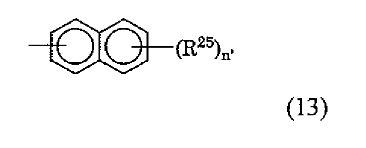

In the general formulas (12) and (13), R²⁵ represents a halogen atom, a hydrocarbon group having 1 to 20 carbon atoms, an alkyl halide group, an alkoxyl groups having 1 to 20 carbon atoms, a phenoxy group, or an aryl group, m' represents an integer from 0 to 5, and n' represents an integer from 0 to 7.

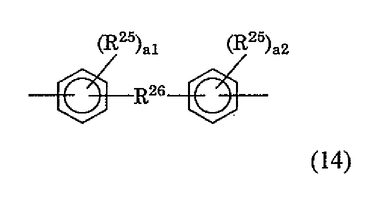

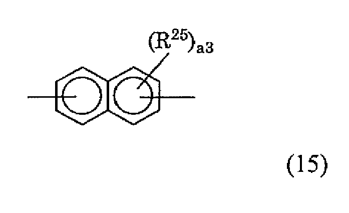

In the general formulas (14) to (15), R²⁵ represents a halogen atom, a hydrocarbon group having 1 to 20 carbon atoms, an alkyl halide group, an alkoxyl group having 1 to 20 carbon atoms, a phenoxy group, or an aryl group, R²⁶ represents a single bond, -O-, -CO-, -CH₂-, -COO-, -CONH-, -S-, -SO₂-, a phenylene group, an isopropylidene group, a hexafluoroisopropylidene group, a diphenylmethylidene group, a metylphenylmethylidene group, a trifluoromethylmethylmethylidene group, trifluoromethylphenylmethylidene group, a fluorenylene group, or a group shown by the following formula, 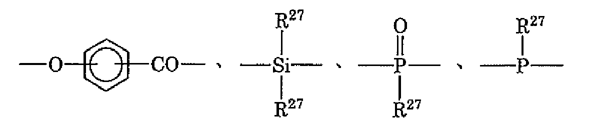 (wherein R²⁷ individually represents a hydrogen atom, a hydrocarbon group having 1 to 4 carbon atoms, or a phenyl group), a1 and a2 individually represent integers from 0 to 4, and a3 represents an integer from 0 to 6.

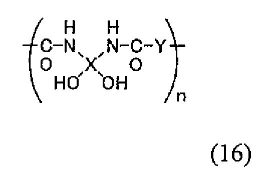

In the general formula (16), n represents an integer from 2 to 1000, X is selected from the following formula (17), and Y is selected from the following formula (18) or (19).

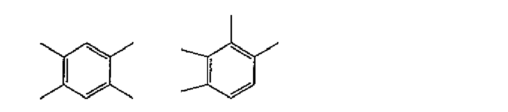

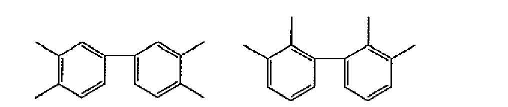

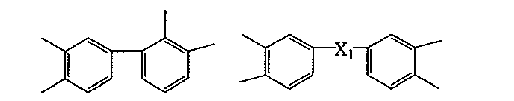

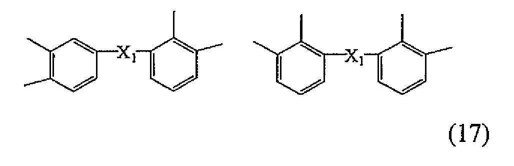

In the general formula (17), X¹ represents a structure selected from the following formula, provided that at least one hydrogen atom on the benzene ring of the structure may be replaced by a monovalent organic group selected from the group consisting of a methyl group, ethyl group, propyl group, isopropyl group, butyl group, isobutyl group, t-butyl group, and phenyl group.

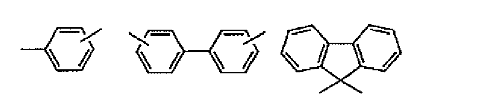

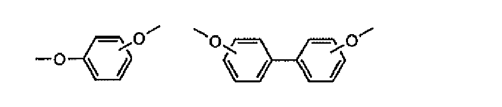

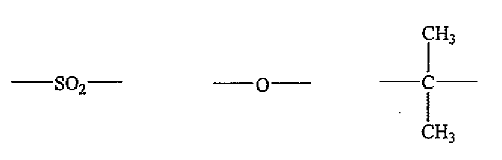

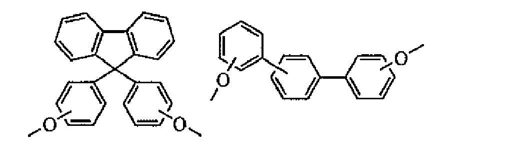

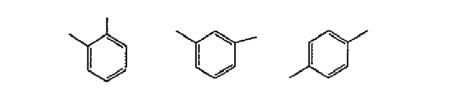

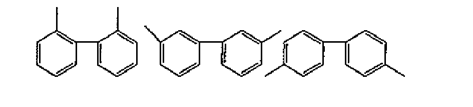

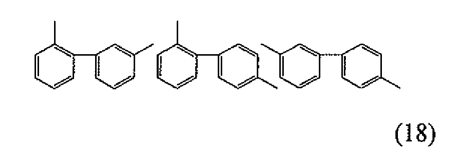

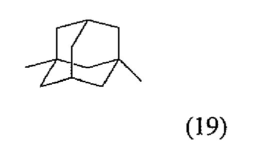

### 3.2 Method of producing composition for forming organic insulating film

A film-forming composition for forming the organic insulating film (hereinafter called "composition 3") is obtained by dissolving or dispersing at least one polymer selected from the polymers shown by the general formulas (5) to (7), (11), and (16) in a solvent. The method of producing the polymers shown by the general formulas (5) to (7), (11), and (16) is described below.

### 3.2.1 Compound 5

The polymer shown by the general formula (5) (compound 5) may be produced by polymerizing a compound 20 shown by the following general formula (20) as a monomer in the presence of a catalyst system containing a transition metal compound. 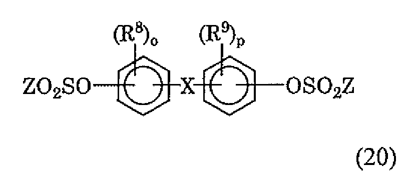 wherein R⁸ and R⁹ individually represent a hydrocarbon group having 1-20 carbon atoms, a cyano group, a nitro group, an alkoxyl group having 1-20 carbon atoms, an aryl group, or a halogen atom, X represents at least one group selected from the group consisting of a group shown by -CQQ'- (wherein Q and Q' individually represent an alkyl halide group, an alkyl group, a hydrogen atom, a halogen atom, or an aryl group) and a fluorenylene group, o and p represent integers from 0 to 4, and Z represents an alkyl group, an alkyl halide group, or an aryl group.

As Q and Q' making up X in the general formula (20), a methyl group, ethyl group, isopropyl group, n-propyl group, butyl group, pentyl group, hexyl group, and the like can be given as the alkyl group; a trifluoromethyl group, pentafluoroethyl group, and the like can be given as the alkyl halide group; a benzyl group, diphenylmethyl group, and the like can be given as the arylalkyl group; a phenyl group, biphenyl group, tolyl group, pentafluorophenyl group, and the like can be given as the aryl group.

As Z making up -OSO₂Z in the general formula (20), a methyl group, ethyl group, and the like can be given as the alkyl group; a trifluoromethyl group, pentafluoroethyl group, and the like can be given as the alkyl halide group; a phenyl group, biphenyl group, p-tolyl group, p-pentafluorophenyl group, and the like can be given as the aryl group. As X in the general formula (20), divalent groups shown by the following formulas (21) to (26) are preferable. Of these divalent groups, a fluorenylene group shown by the general formula (26) is still more preferable.

-C(CH₃)₂- (21)

-C(CF₃)₂- (22)

-C(CF₃)(C₆H₅)- (23)

-CH(CH₃)- (24)

-C(C₆H₅)₂- (25)

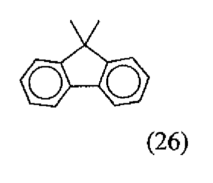

As specific examples of the compound 20 (monomer) shown by the general formula (20), 2,2-bis(4-methylsulfonyloxyphenyl)hexafluoropropane, bis(4-methylsulfonyloxyphenyl)methane, bis(4-methylsulfonyloxyphenyl)diphenylmethane, 2,2-bis(4-methylsulfonyloxy-3-methylphenyl)hexafluoropropane, 2,2-bis(4-methylsulfonyloxy-3-propenylphenyl)hexafluoropropane, 2,2-bis(4-methylsulfonyloxy-3,5-dimethylphenyl)hexafluoropropane, 2,2-bis(4-methylsulfonyloxyphenyl)propane, 2,2-bis(4-methylsulfonyloxy-3-methylphenyl)propane, 2,2-bis(4-methylsulfonyloxy-3-propenylphenyl)propane, 2,2-bis(4-methylsulfonyloxy-3,5-dimethylphenyl)propane, 2,2-bis(4-methylsulfonyloxy-3-fluorophenyl)propane, 2,2-bis(4-methylsulfonyloxy-3,5-difluorophenyl)propane, 2,2-bis(4-trifluoromethylsulfonyloxyphenyl)propane, 2,2-bis(4-trifluoromethylsulfonyloxy-3-propenylphenyl)propane, 2,2-bis(4-phenylsulfonyloxyphenyl)propane, 2,2-bis(4-phenylsulfonyloxy-3-methylphenyl)propane, 2,2-bis(4-phenylsulfonyloxy-3-propenylphenyl)propane, 2,2-bis(4-phenylsulfonyloxy-3,5-dimethylphenyl)propane, 2,2-bis(4-phenylsulfonyloxy-3-fluorophenyl)diphenylmethane, 2,2-bis(p-tolylsulfonyloxyphenyl)propane, 2,2-bis(p-tolylsulfonyloxyphenyl)propane, 2,2-bis(p-tolylsulfonyloxy-propenylphenyl)propane, 2,2-bis(p-tolylsulfonyloxy-3,5-dimethylphenyl)propane, 2,2-bis(p-tolylsulfonyloxy-3-methylphenyl)propane, 2,2-bis(p-tolylsulfonyloxy-3,5-dimethylphenyl)propane, 2,2-bis(p-tolylsulfonyloxy-3-propenylphenyl)propane, bis(p-tolylsulfonyloxy-3-fluorophenyl)propane, bis(p-tolylsulfonyloxy-3,5-difluorophenyl)propane, 9,9-bis(4-methylsulfonyloxyphenyl)fluorene, 9,9-bis(4-methylsulfonyloxy-3-methylphenyl)fluorene, 9,9-bis(4-methylsulfonyloxy-3,5-dimethylphenyl)fluorene, 9,9-bis(4-methylsulfonyloxy-3-propenylphenyl)fluorene, 9,9-bis(4-methylsulfonyloxy-3-phenylphenyl)fluorene, bis(4-methylsulfonyloxy-3-methylphenyl)diphenylmethane, bis(4-methylsulfonyloxy-3,5-dimethylphenyl)diphenylmethane, bis(4-methylsulfonyloxy-3-propenylphenyl)diphenylmethane, bis(4-methylsulfonyloxy-3-fluorophenyl)diphenylmethane, bis(4-methylsulfonyloxy-3,5-difluorophenyl)diphenylmethane, 9,9-bis(4-methylsulfonyloxy-3-fluorophenyl)fluorene, 9,9-bis(4-methylsulfonyloxy-3,5-difluorophenyl)fluorene, bis(4-methylsulfonyloxyphenyl)methane, bis(4-methylsulfonyloxy-3-methylphenyl)methane, bis(4-methylsulfonyloxy-3,5-dimethylphenyl)methane, bis(4-methylsulfonyloxy-3-propenylphenyl)methane, bis(4-methylsulfonyloxyphenyl)trifluoromethylphenylmethane, bis(4-methylsulfonyloxyphenyl)phenylmethane, 2,2-bis(4-trifluoromethylsulfonyloxyphenyl)hexafluoropropane, bis(4-trifluoromethylsulfonyloxyphenyl)methane, bis(4-trifluoromethylsulfonyloxyphenyl)diphenylmethane, 2,2-bis(4-trifluoromethylsulfonyloxy-3-methylphenyl)hexafluoropropane, 2,2-bis(4-trifluoromethylsulfonyloxy-3-propenylphenyl)hexafluoropropane, 2,2-bis(4-trifluoromethylsulfonyloxy-3,5-dimethylphenyl)hexafluoropropane, 9,9-bis(4-trifluoromethylsulfonyloxyphenyl)fluorene, 9,9-bis(4-trifluoromethylsulfonyloxy-3-methylphenyl)fluorene, 9,9-bis(4-trifluoromethylsulfonyloxy-3,5-dimethylphenyl)fluorene, 9,9-bis(4-trifluaromethylsulfonyloxy-3-propenylphenyl)fluorene, 9,9-bis(4-trifluoromethylsulfonyloxy-3-phenylphenyl)fluorene, bis(4-trifluoromethylsulfonyloxy-3-methylphenyl)diphenylmethane, bis(4-trifluoromethylsulfonyloxy-3,5-dimethylphenyl)diphenylmethane, bis(4-trifluoromethylsulfonyloxy-3-propenylphenyl)diphenylmethane, bis(4-trifluoromethylsulfonyloxy-3-fluorophenyl)diphenylmethane, bis(4-trifluoromethylsulfonyloxy-3,5-difluorophenyl)diphenylmethane, 9,9-bis(4-trifluoromethylsulfonyloxy-3-fluorophenyl)fluorene, 9,9-bis(4-trifluoromethylsulfonyloxy-3,5-difluorophenyl)fluorene, bis(4-trifluoromethylsulfonyloxyphenyl)methane, bis(4-trifluoromethylsulfonyloxy-3-methylphenyl)methane, bis(4-trifluoromethylsulfonyloxy-3,5-dimethylphenyl)methane, bis(4-trifluoromethylsulfonyloxy-3-propenylphenyl)methane, bis(4-trifluoromethylsulfonyloxyphenyl)trifluoromethylphenylmethane, bis(4-trifluoromethylsulfonyloxyphenyl), 2,2-bis(4-phenylsulfonyloxyphenyl)hexafluoropropane, bis(4-phenylsulfonyloxyphenyl)methane, bis(4-phenylsulfonyloxyphenyl)diphenylmethane, 2,2-bis(4-phenylsulfonyloxy-3-methylphenyl)hexafluoropropane, 2,2-bis(4-phenylsulfonyloxy-3-propenylphenyl)hexafluoropropane, 2,2-bis(4-phenylsulfonyloxy-3,5-dimethylphenyl)hexafluoropropane, 9,9-bis(4-phenylsulfonyloxyphenyl)fluorene, 9,9-bis(4-phenylsulfonyloxy-3-methylphenyl)fluorene, 9,9-bis(4-phenylsulfonyloxy-3,5-dimethylphenyl)fluorene, 9,9-bis(4-phenylsulfonyloxy-3-propenylphenyl)fluorene, 9,9-bis(4-phenylsulfonyloxy-3-phenylphenyl)fluorene, bis(4-phenylsulfonyloxy-3-methylphenyl)diphenylmethane, bis(4-phenylsulfonyloxy-3,5-dimethylphenyl)diphenylmethane, bis(4-phenylsulfonyloxy-3-propenylphenyl)diphenylmethane, bis(4-phenylsulfonyloxy-3-fluorophenyl)diphenylmethane, bis(4-phenylsulfonyloxy-3,5-difluorophenyl)diphenylmethane, 9,9-bis(4-phenylsulfonyloxy-3-fluorophenyl)fluorene, 9,9-bis(4-phenylsulfonyloxy-3,5-difluorophenyl)fluorene, bis(4-phenylsulfonyloxyphenyl)methane, bis(4-phenylsulfonyloxy-3-methylphenyl)methane, bis(4-phenylsulfonyloxy-3,5-dimethylphenyl)methane, bis(4-phenylsulfonyloxy-3-propenylphenyl)methane, bis(4-phenylsulfonyloxyphenyl)trifluoromethylphenylmethane, bis(4-phenylsulfonyloxyphenyl)phenylmethane, 2,2-bis(p-tolylsulfonyloxyphenyl)hexafluoropropane, bis(p-tolylsulfonyloxyphenyl)methane, bis(p-tolylsulfonyloxyphenyl)diphenylmethane, 2,2-bis(p-tolylsulfonyloxy-3-methylphenyl)hexafluoropropane, 2,2-bis(p-tolylsulfonyloxy-3-propenylphenyl)hexafluoropropane, 2,2-bis(p-tolylsulfonyloxy-3,5-dimethylphenyl)hexafluoropropane, 9,9-bis(p-tolylsulfonyloxyphenyl)fluorene, 9,9-bis(p-tolylsulfonyloxy-3-methylphenyl)fluorene, 9,9-bis(p-tolylsulfonyloxy-3,5-dimethylphenyl)fluorene, 9,9-bis(p-tolylsulfonyloxy-3-propenylphenyl)fluorene, 9,9-bis(p-tolylsulfonyloxy-3-phenylphenyl)fluorene, bis(p-tolylsulfonyloxy-3-methylphenyl)diphenylmethane, bis(p-tolylsulfonytoxy-3,5-dimethylphenyl)diphenylmethane, bis(p-tolylsulfonyloxy-3-propenylphenyl)diphenylmethane, bis(p-tolylsulfonyloxy-3-fluorophenyl)diphenylmethane, bis(p-tolylsulfonyloxy-3,5-difluorophenyl)diphenylmethane, 9,9-bis(p-tolylsulfonyloxyfluorophenyl)fluorene, 9,9-bis(p-tolylsulfonyloxy-3,5-difluorophenyl)fluorene, bis(p-tolylsulfonyloxyphenyl)methane, bis(p-tolylsulfonyloxy-3-methylphenyl)methane, bis(p-tolylsulfonyloxy-3,5-dimethylphenyl)methane, bis(p-tolylsulfonyloxy-3-propenylphenyl)methane, bis(p-tolylsulfonyloxyphenyl)trifluoromethylphenylmethane, bis(p-tolylsulfonyloxyphenyl)phenylmethane, and the like can be given. In the invention, two or more of the compounds 20 shown by the general formula (20) may be copolymerized.

In the invention, at least one of the compounds 20 shown by the general formula (20) may be copolymerized with at least one compound selected from the group consisting of compounds shown by the following general formulas (27) and (28). 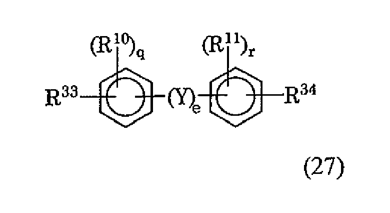 wherein R¹⁰ and R¹¹ individually represent a hydrocarbon group having 1-20 carbon atoms, a cyano group, a nitro group, an alkoxyl group having 1-20 carbon atoms, an aryl group, or a halogen atom, R³³ and R³⁴ represent -OSO₂Z (wherein Z represents an alkyl group, an alkyl halide group, or an aryl group), a chlorine atom, a bromine atom, or an iodine atom, Y represents at least one group selected from the group consisting of -O-, -CO-, -COO-, -CONH-, -S-, -SO₂-, and a phenylene group, e represents 0 to 1, and q and r represent integers from 0 to 4.

As R¹⁰ and R¹¹ in the general formula (27), a fluorine atom and the like can be given as the halogen atom. As the monovalent organic group represented by R¹⁰ and R¹¹, a methyl group, ethyl group, and the like can be given as the alkyl group, a trifluoromethyl group, pentafluoroethyl group, and the like can be given as the alkyl halide group, a propenyl group and the like can be given as the allyl group, and a phenyl group, pentafluorophenyl group, and the like can be given as the aryl group. As Z making up -OSO₂Z in R³³ and R³⁴, a methyl group, ethyl group, and the like can be given as the alkyl group, a trifluoromethyl group and the like can be given as the alkyl halide group, and a phenyl group, p-tolyl group, p-fluorophenyl group, and the like can be given as the aryl group.

As examples of the compound shown by the general formula (27), 4,4'-dimethylsulfonyloxybiphenyl, 4,4'-dimethylsulfonyloxy-3,3'-dipropenylbiphenyl, 4,4'-dibromobiphenyl-4,4'-diiodobiphenyl, 4,4'-dimethylsulfonyloxy-3,3'-dimethylbiphenyl, 4,4'-dimethylsulfonyloxy-3,3'-difluorobiphenyl, 4,4'-dimethylsulfonyloxy-3,3,5,5'-tetrafluorobiphenyl, 4,4'-dibromooctafluorobiphenyl, 4,4'-methylsulfonyloxyoctafluorobiphenyl, 3,3'-diallyl-4,4'-bis(4-fluorobenzenesulfonyloxy)biphenyl, 4,4'-dichloro-2,2'-trifluoromethylbiphenyl, 4,4'-dibromo-2,2'-trifluoromethylbiphenyl, 4,4'-diiodo-2,2'-trifluoromethylbiphenyl, bis(4-chlorophenyl)sulfone, 4,4'-dichlorobenzophenone, 2,4-dichlorobenzophenone, and the like can be given. The compound shown by the general formula (27) may be used either individually or in combination of two or more. 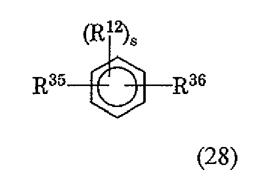 wherein R¹² represents a hydrocarbon group having 1-20 carbon atoms, a cyano group, a nitro group, an alkoxyl group having 1-20 carbon atoms, an aryl group, or a halogen atom, R³⁵ and R³⁶ represent -OSO₂Z (wherein Z represents an alkyl group, an alkyl halide group, or an aryl group), a chlorine atom, a bromine atom, or an iodine atom, and s represents an integer from 0 to 4.

As R¹² in the general formula (28), a fluorine atom and the like can be given as the halogen atom, a methyl group, ethyl group, and the like can be given as the alkyl group, a trifluoromethyl group, pentafluoroethyl group, and the like can be given as the alkyl halide group, a propenyl group and the like can be given as the allyl group, and a phenyl group, pentafluorophenyl group, and the like can be given as the aryl group. As Z making up -OSO₂Z in R³⁵ and R³⁶, a methyl group, ethyl group, and the like can be given as the alkyl group, a trifluoromethyl group and the like can be given as the alkyl halide group, and a phenyl group, p-tolyl group, p-fluorophenyl group, and the like can be given as the aryl group.

As examples of the compound shown by the general formula (28), o-dichlorobenzene, o-dibromobenzene, o-diiodobenzene, o-dimethylsulfonyloxybenzene, 2,3-dichlorotoluene, 2,3-dibromotoluene, 2,3-diiodotoluene, 3,4-dichlorotoluene, 3,4-dibromotoluene, 3,4-diiodotoluene, 2,3-dimethylsulfonyloxybenzene, 3,4-dimethylsulfonyloxybenzene, m-dichlorobenzene, m-dibromobenzene, m-diiodobenzene, m-dimethylsulfonyloxybenzene, 2,4-dichlorotoluene, 2,4-dibromotoluene, 2,4-diiodotoluene, 3,5-dichlorotoluene, 3,5-dibromotoluene, 3,5-diiodotoluene, 2,6-dichlorotoluene, 2,6-dibromotoluene, 2,6-diiodotoluene, 3,5-dimethylsulfonyloxytoluene, 2,6-dimethylsulfonyloxytoluene, 2,4-dichlorobenzotrifluoride, 2,4-dibromobenzotrifluoride, 2,4-diiodobenzotrifluoride, 3,5-dichlorobenzotrifluoride, 3,5-dibromotrifluoride, 3,5-diiodobenzotrifluoride, 1,3-dibromo-2,4,5,6-tetrafluorobenzene, 2,4-dichlorobenzylalcohol, 3,5-dichlorobenzylalcohol, 2,4-dibromobenzylalcohol, 3,5-dibromobenzylalcohol, 3,5-dichlorophenol, 3,5-dibromophenol, 3,5-dichloro-tert-butoxycarbonyloxyphenyl, 3,5-dibromo-tert-butoxycarbonyloxyphenyl, 2,4-dichlorobenzoic acid, 3,5-dichlorobenzoic acid, 2,4-dibromobenzoic acid, 3,5-dibromobenzoic acid, methyl 2,4-dichlorobenzoate, methyl 3,5-dichlorobenzoate, methyl 3,5-dibromobenzoate, methyl 2,4-dibromobenzoate, t-butyl 2,4-dichlorobenzoate, t-butyl 3,5-dichlorobenzoate, t-butyl 2,4-dibromobenzoate, t-butyl 3,5-dibromobenzoate, and the like can be given. Of these, m-dichlorobenzene, 2,4-dichlorotoluene, 3,5-dimethylsulfonyloxytoluene, 2,4-dichlorobenzotrifluoride, 2,4-dichlorobenzophenone, 2,4-dichlorophenoxybenzene, and the like are preferable. The compound shown by the general formula (28) may be used either individually or in combination of two or more.

The ratio of the repeating units in the compound 5 is determined so that, in the general formula (5), f is 5 to 100 mol%, and preferably 5 to 95 mol%, g is 0 to 95 mol%, and preferably 0 to 90 mol%, and h is 0 to 95 mol%, and preferably 0 to 90 mol% (f+g+h = 100 mol%). If f is less than 5 mol% (g or h exceeds 95 mol%), the solubility of the polymer in the organic solvent may be insufficient.

As the catalyst used when producing the compound 5, a catalyst system containing a transition metal compound is preferable. The catalyst system includes, as essential components, (I) a transition metal salt and a ligand, or a transition metal (salt) to which a ligand is coordinated, and (II) a reducing agent. A "salt" may be further added in order to increase the polymerization rate. As examples of the transition metal salt, nickel compounds such as nickel chloride, nickel bromide, nickel iodide, and nickel acetylacetonate, palladium compounds such as palladium chloride, palladium bromide, and palladium iodide, iron compounds such as iron chloride, iron bromide, and iron iodide, cobalt compounds such as cobalt chloride, cobalt bromide, and cobalt iodide, and the like can be given. Of these, nickel chloride and nickel bromide are preferable.

As examples of the ligand, triphenylphosphine, 2,2'-bipyridine, 1,5-cyclooctadiene, 1,3-bis(diphenylphosphino)propane, and the like can be given. Of these, triphenylphosphine and 2,2'-bipyridine are preferable. The ligand may be used either individually or in combination of two or more. As examples of the transition metal (salt) to which a ligand is coordinated in advance, 2-triphenylphosphine nickel chloride, 2-triphenylphosphine nickel bromide, 2-triphenylphosphine nickel iodide, 2-triphenylphosphine nickel nitrate, 2,2'-bipyridine nickel chloride, 2,2'-bipyridine nickel bromide, 2,2'-bipyridine nickel iodide, 2,2'-bipyridine nickel nitrate, bis(1,5-cyclooctadiene)nickel, tetrakis(triphenylphosphine)nickel, tetrakis(triphenylphosphite)nickel, tetrakis(triphenylphosphine)palladium, and the like can be given. Of these, 2-triphenylphosphine nickel chloride and 2,2'-bipyridine nickel chloride are preferable.

As examples of the reducing agent which may be used in the catalyst system, iron, zinc, manganese, aluminum, magnesium, sodium, calcium, and the like can be given. Of these, zinc and manganese are preferable. The reducing agent may be used in a more activated state by causing the reducing agent to come in contact with an acid or an organic acid. As examples of the "salt" which may be used in the catalyst system, sodium compounds such as sodium fluoride, sodium chloride, sodium bromide, sodium iodide, and sodium sulfate, potassium compounds such as potassium fluoride, potassium chloride, potassium bromide, potassium iodide, and potassium sulfate, ammonium compounds such as tetraethylammonium fluoride, tetraethylammonium chloride, tetraethylammonium bromide, tetraethylammonium iodide, and tetraethylammonium sulfate, and the like can be given. Of these, sodium bromide, sodium iodide, potassium bromide, tetraethylammonium bromide, and tetraethylammonium iodide are preferable.

The amount of the transition metal salt or the transition metal (salt) to which a ligand is coordinated to be used in the catalyst system is usually 0.0001 to 10 mol, and preferably 0.01 to 0.5 mol for one mol of the total amount of the compounds shown by the general formula (20), the general formula (27), and the general formula (28). If the amount is less than 0.0001 mol, the polymerization reaction does not proceed sufficiently. If the amount exceeds 10 mol, the molecular weight may be decreased. When using the transition metal salt and the ligand in the catalyst system, the amount of the ligand to be used is usually 0.1 to 100 mol, and preferably 1 to 10 mol for one mol of the transition metal salt. If the amount is less than 0.1 mol, the catalytic activity may be insufficient. If the amount exceeds 100 mol, the molecular weight may be decreased. The amount of the reducing agent to be used in the catalyst system is usually 0.1 to 100 mol, and preferably 1 to 10 mol for one mol of the total amount of the compounds shown by the general formula (20), the general formula (27), and the general formula (28). If the amount is less than 0.1 mol, polymerization does not proceed sufficiently. If the amount exceeds 100 mol, it may be difficult to purify the resulting polymer.

When using the "salt" in the catalyst system, the amount of the "salt" to be used is usually 0.001 to 100 mol, and preferably 0.01 to 1 mol for one mol of the total amount of the compounds shown by the general formula (20), the general formula (27), and the general formula (28). If the amount is less than 0.001 mol, the effect of increasing the polymerization rate may be insufficient. If the amount exceeds 100 mol, it may be difficult to purify the resulting polymer.

As the polymerization solvent which may be used in the invention, tetrahydrofuran, cyclohexanone, dimethylsulfoxide, N,N-dimethylformamide, N,N-dimethylacetamide, 1-methyl-2-pyrrolidone, γ-butyrolactone, γ-butyrolactam, and the like can be given. Of these, tetrahydrofuran, N,N-dimethylformamide, N,N-dimethylacetamide, and 1-methyl-2-pyrrolidone are preferable. It is preferable to use the polymerization solvent after sufficiently drying the polymerization solvent. The total concentration of the compounds shown by the general formula (20), the general formula (27), and the general formula (28) in the polymerization solvent is usually 1 to 100 wt%, and preferably 5 to 40 wt%. The polymerization temperature when polymerizing the polymer is usually 0 to 200°C, and preferably 50 to 80°C. The polymerization time is usually 0.5 to 100 hours, and preferably 1 to 40 hours. The polystyrene-reduced weight average molecular weight of the compound 5 is usually 1,000 to 1,000,000.

### 3.2.2 Compound 6

The polymer shown by the general formula (6) (hereinafter may be called "compound 6") may be produced by polymerizing monomers including compounds shown by the following general formulas (29) to (31) in the presence of a catalyst system, for example. 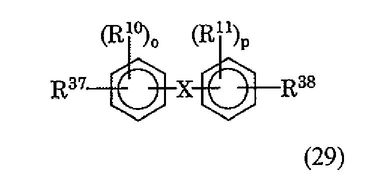 wherein R¹⁰ and R¹¹ individually represent a hydrocarbon group having 1-20 carbon atoms, a cyano group, a nitro group, an alkoxyl group having 1-20 carbon atoms, an aryl group, or a halogen atom, X represents at least one group selected from a group shown by -CQQ'- (wherein Q and Q' individually represent an alkyl halide group, an alkyl group, a hydrogen atom, a halogen atom, or an aryl group) and a fluorenylene group, o and p represent integers from 0 to 4, and R³⁷ and R³⁸ represent at least one group or atom selected from the group consisting of a hydroxyl group, a halogen atom, and a -OM' group (wherein M' represents an alkali metal).

As specific examples of the compound (monomer) shown by the general formula (29), 2,2-bis(4-hydroxyphenyl)hexafluoropropane, bis(4-hydroxyphenyl)methane, bis(4-hydroxyphenyl)diphenylmethane, 2,2-bis(4-hydroxy-3-methylphenyl)hexafluoropropane, 2,2-bis(4-hydroxy-3-propenylphenyl)hexafluoropropane, 2,2-bis(4-hydroxy-3,5-dimethylphenyl)hexafluoropropane, 2,2-bis(4-hydroxyphenyl)propane, 2,2-bis(4-hydroxy-3-methylphenyl)propane, 2,2-bis(4-hydroxy-3-propenylphenyl)propane, 2,2-bis(4-hydroxy-3,5-dimethylphenyl)propane, 2,2-bis(4-hydroxy-3-fluorophenyl)propane, 2,2-bis(4-hydroxy-3,5-difluorophenyl)propane, 2,2-bis(4-chlorophenyl)hexafluoropropane, bis(4-chlorophenyl)methane, bis(4-chlorophenyl)diphenylmethane, 2,2-bis(4-chloro-3-methylphenyl)hexafluoropropane, 2,2-bis(4-chloro-3-propenylphenyl)hexafluoropropane, 2,2-bis(4-chloro-3,5-dimethylphenyl)hexafluoropropane, 2,2-bis(4-chlorophenyl)propane, 2,2-bis(4-chloro-3-methylphenyl)propane, 2,2-bis(4-chloro-3-propenylphenyl)propane, 2,2-bis(4-chloro-3,5-dimethylphenyl)propane, 2,2-bis(4-chloro-3-fluorophenyl)propane, 2,2-bis(4-chloro-3,5-difluorophenyl)propane, 2,2-bis(4-chlorophenyl)hexafluoropropane, bis(4-bromophenyl)methane, bis(4-bromophenyl)diphenylmethane, 2,2-bis(4-bromo-3-methylphenyl)hexafluoropropane, 2,2-bis(4-bromo-3-propenylphenyl)hexafluoropropane, 2,2-bis(4-bromo-3,5-dimethylphenyl)hexafluoropropane, 2,2-bis(4-bromophenyl)propane, 2,2-bis(4-bromo-3-methylphenyl)propane, 2,2-bis(4-bromo-3-propenylphenyl)propane, 2,2-bis(4-bromo-3,5-dimethylphenyl)propane, 2,2-bis(4-bromo-3-fluorophenyl)propane, 2,2-bis(4-broma-3,5-difluorophenyl)propane, bis(4-fluorophenyl)methane, bis(4-fluorophenyl)diphenylmethane, 2,2-bis(4-fluoro-3-methylphenyl)hexafluoropropane, 2,2-bis(4-fluoro-3-propenylphenyl)hexafluoropropane, 2,2-bis(4-fluoro-3,5-dimethylphenyl)hexafluoropropane, 2,2-bis(4-fluorophenyl)propane, 2,2-bis(4-fluoro-3-methylphenyl)propane, 2,2-bis(4-fluoro-3-propenylphenyl)propane, 2,2-bis(4-fluoro-3,5-dimethylphenyl)propane, 2,2-bis(4-fluoro-3-fluorophenyl)propane, 2,2-bis(4-fluoro-3,5-difluorophenyl)propane, and the like can be given. A hydroxyl group in the bisphenol compound may be replaced by the -OM' group (wherein M' represents an alkali metal) by using a basic compound containing sodium, potassium, or the like. In the invention, two or more of the compounds shown by the general formula (29) may be copolymerized. 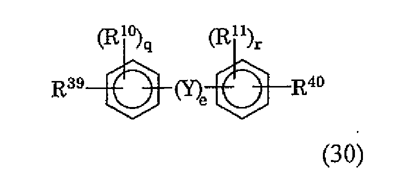 wherein R¹⁰ and R¹¹ individually represent a hydrocarbon group having 1-20 carbon atoms, a cyano group, a nitro group, an alkoxyl group having 1-20 carbon atoms, an aryl group, or a halogen atom, R³⁹ and R⁴⁰ represent at least one group or atom selected from the group consisting of a hydroxyl group, a halogen atom, and a -OM' group (wherein M' represents an alkali metal), Y represents at least one group selected from the group consisting of -O-, -CO-, -COO-, -CONH-, -S-, -SO₂- and a phenylene group, e represents 0 to 1, and q and r represent integers from 0 to 4.

As examples of the compound shown by the general formula (30), 4,4'-dichlorobiphenyl, 4,4'-dibromobiphenyl, 4,4'-difluorobiphenyl, 4,4'-diiodobiphenyl, 4,4'-dihydroxybiphenyl, 4,4'-dihydroxy-3,3'-dipropenylbiphenyl, 4,4'-dihydroxy-3,3'-dimethylbiphenyl, 4,4'-dihydroxy-3,3'-diethylbiphenyl, 4,4'-dimethylhydroxy-3,3',5,5'-tetrafluorobiphenyl, 4,4'-dibromooctafluorobiphenyl, 4,4-dihydroxyoctafluorobiphenyl, 3,3'-diallyl-4,4'-bis(4-hydroxy)biphenyl, 4,4'-dichloro-2,2'-trifluoromethylbiphenyl, 4,4'-dibromo-2,2'-trifluoromethylbiphenyl, 4,4'-diiodo-2,2'-trifluoromethylbiphenyl, bis(4-chlorophenyl)sulfone, bis(4-hydroxyphenyl)sulfone, bis(4-chlorophenyl) ether, bis(4-hydroxyphenyl) ether, 4,4'-dichlorobenzophenone, 4,4'-dihydroxybenzophenone, 2,4-dichlorobenzophenone, 2,4-dihydroxybenzophenone, and the like can be given. A hydroxyl group in the bisphenol compound may be replaced by the -OM' group (wherein M' represents an alkali metal) by using a basic compound containing sodium, potassium, or the like. The compound shown by the general formula (30) may be used either individually or in combination of two or more. 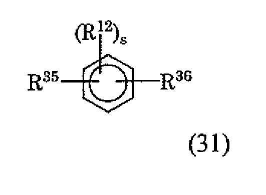 wherein R¹² represents a hydrocarbon group having 1-20 carbon atoms, a cyano group, a nitro group, an alkoxyl group having 1-20 carbon atoms, an aryl group, or a halogen atom, R³⁵ and R³⁶ represent -OSO₂Z (wherein Z represents an alkyl group, an alkyl halide group, or an aryl group), a chlorine atom, a bromine atom, or an iodine atom, and s represents an integer from 0 to 4.

As examples of the compound shown by the general formula (31), 1,2-dihydroxybenzene, 1,3-dihydroxybenzene, 1,4-dihydroxybenzene, 2,3-dihydroxytoluene, 2,5-dihydroxytoluene, 2,6-dihydroxytoluene, 3,4-dihydroxytoluene, 3,5-dihydroxytoluene, o-dichlorobenzene, o-dibromobenzene, o-diiodobenzene, o-dimethylsulfonyloxybenzene, 2,3-dichlorotoluene, 2,3-dibromotoluene, 2,3-diiodotoluene, 3,4-dichlorotoluene, 3,4-dibromotoluene, 3,4-diiodotoluene, 2,3-dimethylsulfonyloxybenzene, 3,4-dimethylsulfonyloxybenzene, m-dichlorobenzene, m-dibromobenzene, m-diiodobenzene, m-dimethylsulfonyloxybenzene, 2,4-dichlorotoluene, 2,4-dibromotoluene, 2,4-diiodotoluene, 3,5-dichlorotoluene, 3,5-dibromotoluene, 3,5-diiodotoluene, 2,6-dichlorotoluene, 2,6-dibromotoluene, 2,6-diiodotoluene, 3,5-dimethylsulfonyloxytoluene, 2,6-dimethylsulfonyloxytoluene, 2,4-dichlorobenzotrifluoride, 2,4-dibromobenzotrifluoride, 2,4-diiodobenzotrifluoride, 3,5-dichlorobenzotrifluoride, 3,5-dibromotrifluoride, 3,5-diiodobenzotrifluoride, 1,3-dibromo-2,4,5,6-tetrafluorobenzene, 2,4-dichlorobenzylalcohol, 3,5-dichlorobenzylalcohol, 2,4-dibromobenzylalcohol, 3,5-dibromobenzylalcohol, 3,5-dichlorophenol, 3,5-dibromophenol, 3,5-dichloro-tert-butoxycarbonyloxyphenyl, 3,5-dibromo-tert-butoxycarbonyloxyphenyl, 2,4-dichlorobenzoic acid, 3,5-dichlorobenzoic acid, 2,4-dibromobenzoic acid, 3,5-dibromobenzoic acid, methyl 2,4-dichlorobenzoate, methyl 3,5-dichlorobenzoate, methyl 3,5-dibromobenzoate, methyl 2,4-dibromobenzoate, t-butyl 2,4-dichlorobenzoate, t-butyl 3,5-dichlorobenzoate, t-butyl 2,4-dibromobenzoate, t-butyl 3,5-dibromobenzoate, and the like can be given. A hydroxyl group in the bisphenol compound may be replaced by the -OM' group (wherein M' represents an alkali metal) by using a basic compound containing sodium, potassium, or the like. The compound shown by the general formula (31) may be used either individually or in combination of two or more. The ratio of the repeating units in the compound 6 shown by the general formula (6) is determined so that I is 0 to 100 mol% and j is 0 to 100 mol% (I+j = 100 mol%) in the general formula (6).

The compound 6 shown by the general formula (6) may be synthesized by heating the bisphenol compound and the dihalide compound in a solvent in the presence of an alkali metal compound, for example. The bisphenol compound is used in an amount of 45 to 55 mol%, and preferably 48 to 52 mol%, and the dihalide compound is used in an amount of 55 to 45 mol%, and preferably 52 to 48 mol%. If the amount of the bisphenol compound used is less than 45 mol% or exceeds 55 mol%, the molecular weight of the polymer is not sufficiently increased, whereby the coating applicability may be decreased. As examples of the alkali metal compound used to synthesize the compound 6, sodium hydroxide, potassium hydroxide, lithium hydroxide, sodium carbonate, potassium carbonate, lithium carbonate, sodium hydrogencarbonate, potassium hydrogencarbonate, lithium hydrogencarbonate, sodium hydride, potassium hydride, lithium hydride, metallic sodium, metallic potassium, metallic lithium, and the like can be given. These compounds may be used either individually or in combination of two or more. The alkali metal compound is used in an amount of usually 100 to 400 mol%, and preferably 100 to 250 mol% for the bisphenol compound. In order to promote the reaction, a promoter such as metallic copper, cuprous chloride, cupric chloride, cuprous bromide, cupric bromide, cuprous iodide, cupric iodide, cuprous sulfate, cupric sulfate, cuprous acetate, cupric acetate, cuprous formate, or cupric formate may be used. The promoter is used in an amount of usually 1 to 50 mol%, and preferably 1 to 30 mol% for the bisphenol compound.

As the solvent used for the reaction, pyridine, quinoline, benzophenone, diphenyl ether, dialkoxybenzene (the number of carbon atoms of the alkoxyl group is 1 to 4), trialkoxybenzene (the number of carbon atoms of the alkoxyl group is 1 to 4), diphenylsulfone, dimethylsulfoxide, dimethylsulfone, diethylsulfoxide, diethylsulfone, diisopropylsulfone, tetrahydrofuran, tetrahydrothiophene, sulfolane, N-methyl-2-pyrrolidone, N-ethyl-2-pyrrolidone, dimethylimidazolidinone, γ-butyrolactone, dimethylformamide, dimethylacetamide, or the like may be used. These compounds may be used either individually or in combination of two or more. The reaction concentration when synthesizing the compound 6 shown by the general formula (6) is 2 to 50 wt% based on the weight of the monomers, and the reaction temperature is 50 to 250°C. In order to remove metal salts and unreacted monomers produced during synthesis of the polymer, it is preferable to filter the reaction solution, reprecipitate the reaction solution from a poor solvent for the polymer, or wash the reaction solution with an acidic or alkaline solution. The weight average molecular weight of the resulting compound 6 determined by the GPC method is usually 500 to 500,000, and preferably 800 to 100,000.

### 3.2.3 Compound 7

The polymer 7 shown by the general formula (7) (hereinafter may be called "compound 7") may be produced by polymerizing at least one compound selected from the group consisting of compounds shown by the following general formulas (32) and (33) and at least one compound selected from the group consisting of compounds shown by the following general formulas (34) and (35) in the presence of a catalyst, for example. 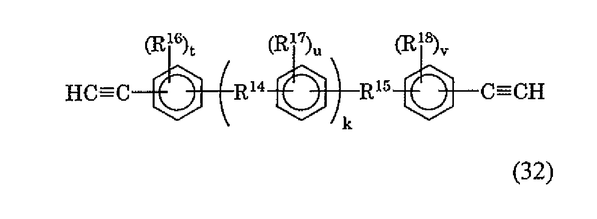 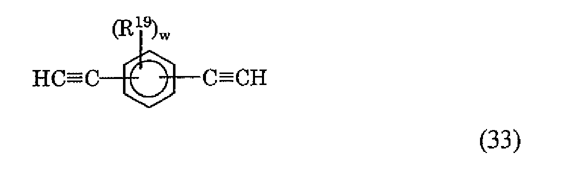 wherein R¹⁴ to R¹⁹ and k, t, u, v, and w are the same as defined for the general formulas (8) and (9). 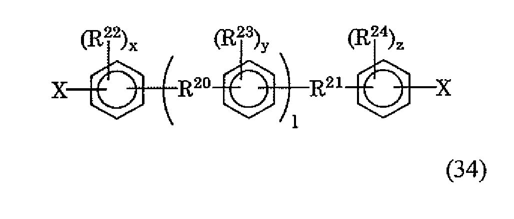 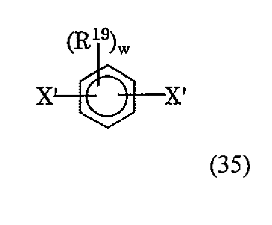 wherein R¹⁹ to R²⁴ and l, w, x, y, and z are the same as defined for the general formulas (9) and (10), and X' represents a halogen atom.

As examples of the compound shown by the general formula (32), 4,4'-diethynylbiphenyl, 3,3'-diethynylbiphenyl, 3,4'-diethynylbiphenyl, 4,4'-diethynyldiphenyl ether, 3,3'-diethynyldiphenyl ether, 3,4'-diethynyldiphenyl ether, 4,4'-diethynylbenzophenone, 3,3'-diethynylbenzophenone, 3,4'-diethynylbenzophenone, 4,4'-diethynyldiphenylmethane, 3,3'-diethynyldiphenylmethane, 3,4'-diethynyldiphenylmethane, phenyl 4,4'-diethynylbenzoate, phenyl 3,3'-diethynylbenzoate, phenyl 3,4'-diethynylbenzoate, 4,4'-diethynylbenzanilide, 3,3'-diethynylbenzanitide, 3,4'-diethynylbenzanilide, 4,4'-diethynyldiphenylsulfide, 3,3'-diethynyldiphenylsulfide, 3,4'-diethynyldiphenylsulfide, 4,4'-diethynyldiphenylsulfone, 3,3'-diethynyldiphenylsulfone, 3,4'-diethynyldiphenylsulfone, 2,4,4'-triethynyldiphenyl ether, 9,9-bis(4-ethynylphenyl)fluorene, 4,4"-diethynyl-p-terphenyl, 4,4"-diethynyl-m-terphenyl, 4,4"-diethynyl-o-terphenyl, and the like can be given. These compounds may be used either individually or in combination of two or more.

As examples of the compound shown by the general formula (33), 1,2-diethynylbenzene, 1,3-diethynylbenzene, 1,4-diethynylbenzene, 2,5-diethynyltoluene, 3,4-diethynyltoluene, and the like can be given. These compounds may be used either individually or in combination of two or more.

As examples of the compound shown by the general formula (34), 1,2-bis(2-bromophenoxy)benzene, 1,2-bis(2-iodophenoxy)benzene, 1,2-bis(3-bromophenoxy)benzene, 1,2-bis(3-iodophenoxy)benzene, 1,2-bis(4-bromophenoxy)benzene, 1,2-bis(4-iodophenoxy)benzene, 1,3-bis(2-bromophenoxy)benzene, 1,3-bis(2-iodophenoxy)benzene, 1,3-bis(3-bromophenoxy)benzene, 1,3-bis(3-iodophenoxy)benzene, 1,3-bis(4-bromophenoxy)benzene, 1,3-bis(4-iodophenoxy)benzene, 1,4-bis(3-bromophenoxy)benzene, 1,4-bis(3-iodophenoxy)benzene, 1,4-bis(2-bromophenoxy)benzene, 1,4-bis(2-iodophenoxy)benzene, 1,4-bis(4-bromophenoxy)benzene, 1,4-bis(4-iodophenoxy)benzene, 1-(2-bromobenzoyl)-3-(2-bromophenoxy)benzene, 1-(2-iodobenzoyl)-3-(2-iodophenoxy)benzene, 1-(3-bromobenzoyl)-3-(3-bromophenoxy)benzene, 1-(3-iodobenzoyl)-3-(3-iodophenoxy)benzene, 1-(4-bromobenzoyl)-3-(4-bromophenoxy)benzene, 1-(4-iodobenzoyl)-3-(4-iodophenoxy)benzene, 1-(3-bromobenzoyl)-4-(3-bromophenoxy)benzene, 1-(3-iodobenzoyl)-4-(3-iodophenoxy)benzene, 1-(4-bromobenzoyl)-4-(4-bromophenoxy)benzene, 1-(4-iodobenzoyl)-4-(4-iodophenoxy)benzene, 2,2'-bis(2-bromophenoxy)benzophenone, 2,2'-bis(2-iodophenoxy)benzophenone, 2,4'-bis(2-bromophenoxy)benzophenone, 2,4'-bis(2-iodophenoxy)benzophenone, 4,4'-bis(2-bromophenoxy)benzophenone, 4,4'-bis(2-iodophenoxy)benzophenone, 2,2'-bis(3-bromophenoxy)benzophenone, 2,2'-bis(3-iodophenoxy)benzophenone, 2,4'-bis(3-bromophenoxy)benzophenone, 2,4'-bis(3-iodophenoxy)benzophenone, 4,4'-bis(3-bromophenoxy)benzophenone, 4,4'-bis(3-iodophenoxy)benzophenone, 2,2'-bis(4-bromophenoxy)benzophenone, 2,2'-bis(4-iodophenoxy)benzophenone, 2,4'-bis(4-bromophenoxy)benzophenone, 2,4'-bis(4-iodophenoxy)benzophenone, 4,4'-bis(4-bromophenoxy)benzophenone, 4,4'-bis(4-iodophenoxy)benzophenone, 2,2'-bis(2-bromobenzoyl)benzophenone, 2,2'-bis(2-iodobenzoyl)benzophenone, 2,4'-bis(2-bromobenzoyl)benzophenone, 2,4'-bis(2-iodobenzoyl)benzophenone, 4,4'-bis(2-bromobenzoyl)benzophenone, 4,4'-bis(2-iodobenzoyl)benzophenone, 2,2'-bis(3-bromobenzoyl)benzophenone, 2,2'-bis(3-iodobenzoyl)benzophenone, 2,4'-bis(3-bromobenzoyl)benzophenone, 2,4'-bis(3-iodobenzoyl)benzophenane, 4,4'-bis(3-bromobenzoyl)benzophenone, 4,4'-bis(3-iodobenzoyl)benzophenone, 2,2'-bis(4-bromobenzoyl)benzophenone, 2,2'-bis(4-iodobenzoyl)benzophenone, 2,4'-bis(4-bromobenzoyl)benzophenone, 2,4'-bis(4-iodobenzoyl)benzophenone, 4,4'-bis(4-bromobenzoyt)benzophenone, 4,4'-bis(4-iodobenzoyt)benzophenone, 3,4'-bis(2-bromophenoxy)diphenyl ether, 3,4'-bis(2-iodophenoxy)diphenyl ether, 3,4'-bis(3-bromophenoxy)diphenyl ether, 3,4'-bis(3-iodophenoxy)diphenyl ether, 3,4'-bis(4-bromophenoxy)diphenyl ether, 3,4'-bis(4-iodophenoxy)diphenyl ether, 4,4'-bis(2-bromophenoxy)diphenyl ether, 4,4'-bis(2-iodophenoxy)diphenyl ether, 4,4'-bis(3-bromophenoxy)diphenyl ether, 4,4'-bis(3-iodophenoxy)diphenyl ether, 4,4'-bis(4-bromophenoxy)diphenyl ether, 4,4'-bis(4-iodophenoxy)diphenyl ether, 3,4'-bis(2-bromobenzoyl)diphenyl ether, 3,4'-bis(2-iodobenzoyl)diphenyl ether, 3,4'-bis(3-bromobenzoyl)diphenyl ether, 3,4'-bis(3-iodobenzoyl)diphenyl ether, 3,4'-bis(4-bromobenzoyl)diphenyl ether, 3,4'-bis(4-iodobenzoyl)diphenyl ether, 4,4'-bis(2-bromobenzoyl)diphenyl ether, 4,4'-bis(2-iodobenzoyl)diphenyl ether, 4,4'-bis(3-bromobenzoyl)diphenyl ether, 4,4'-bis(3-iodobenzoyl)diphenyl ether, 4,4'-bis(4-bromobenzoyl)diphenyl ether, 4,4'-bis(4-iodobenzoyl)diphenyl ether, 2,2'-bis(4-chlorophenyl)diphenylmethylidene, 2,2'-bis(4-iodophenyl)diphenylmethylidene, 2,2'-bis(4-bromophenyl)diphenylmethylidene, 2,2'-bis(3-chlorophenyl)diphenylmethylidene, 2,2'-bis(3-iodophenyl)diphenylmethylidene, 2,2'-bis(3-bromophenyl)diphenylmethylidene, 9,9-bis(4-chlorophenyl)fluorene, 9,9-bis(4-iodophenyl)fluorene, 9,9-bis(4-bromophenyl)fluorene, 9,9-bis(3-chlorophenyl)fluorene, 9,9-bis(3-iodophenyl)fluorene, 9,9-bis(3-bromophenyl)fluorene, 4,4"-dichloro-m-terphenyl, 4,4"-diiodo-m-terphenyl, 4,4"-dibromo-m-terphenyl, 4,4"-dichloro-p-terphenyl, 4,4"-diiodo-p-terphenyl, 4,4"-dibromo-p-terphenyl, and the like can be given. These compounds may be used either individually or in combination of two or more.

As examples of the compound shown by the general formula (35), 1,2-dichlorobenzene, 1,3-dichlorobenzene, 1,4-dichlorobenzene, 1,2-diiodobenzene, 1,3-diiodobenzene, 1,4-diiodobenzene, 1,2-dibromobenzene, 1,3-dibromobenzene, 1,4-dibromobenzene, 2,3-dichlorotoluene, 2,4-dichlorotoluene, 2,5-dichlorotoluene, 2,6-dichlorotoluene, 3,4-dichlorotoluene, 2,3-diiodotoluene, 2,4-diiodotoluene, 2,5-diiodotoluene, 2,6-diiodotoluene, 3,4-diiodotoluene, 2,3-dibromotoluene, 2,4-dibromotoluene, 2,5-dibromotoluene, 2,6-dibromotoluene, 3,4-dibromotoluene, and the like can be given. These compounds may be used either individually or in combination of two or more.

In the invention, the compound 7 is produced by polymerizing the compound shown by the general formula (32) and/or the compound shown by the general formula (33) and the compound shown by the general formula (34) and/or the compound shown by the general formula (35) in the presence of a catalyst. The compound shown by the general formula (32) and/or the compound shown by the general formula (33) and the compound shown by the general formula (34) and/or the compound shown by the general formula (35) are used so that the total amount of the compound shown by the general formula (34) and/or the compound shown by the general formula (35) is 0.8 to 1.2 mol, preferably 0.9 to 1.1 mol, and particularly preferably 0.95 to 1.05 mol for one mol of the total amount of the compound shown by the general formula (32) and/or the compound shown by the general formula (33). If the total amount of the compound shown by the general formula (34) and/or the compound shown by the general formula (35) is less than 0.8 mol or exceeds 1.2 mol, the molecular weight of the resulting polymer is not sufficiently increased.

In the production of the compound 7, it is preferable to polymerize the compounds shown by the general formulas (32) to (35) in the presence of a catalyst containing a transition metal compound. A catalyst containing a transition metal compound and a basic compound is preferable, with a catalyst containing the following components (a), (b), and (c) being particularly preferable.
(a) Palladium salt and substance which bonds to palladium as ligand or which can supply group (atomic group) which bonds to palladium as ligand to form complex (including complex ion) (hereinafter called "ligand-forming substance"), or palladium complex (ligand-forming substance may be added, if necessary)
(b) Monovalent copper compound
(c) Basic compound

As examples of the palladium salt used as the component (a), palladium chloride, palladium bromide, palladium iodide, and the like can be given. These compounds may be used either individually or in combination of two or more. The palladium salt is used in an amount of usually 0.0001 to 10 mol, and preferably 0.001 to 1 mol for one mol of the total amount of the compounds shown by the general formulas (32) to (35). If the amount is less than 0.0001 mol, polymerization may not proceed sufficiently. If the amount exceeds 10 mol, it may be difficult to purify the resulting polymer.

As examples of the ligand-forming substance used as the component (a), triphenylphosphine, tri-o-tolylphosphine, tricyanophenylphosphine, tricyanomethylphosphine, and the like can be given. Of these, triphenylphosphine is preferable. These compounds may be used either individually or in combination of two or more. The ligand-forming substance is used in an amount of usually 0.0004 to 50 mol, and preferably 0.004 to 5 mol for one mol of the total amount of the compounds shown by the general formulas (32) to (35). If the amount is less than 0.0004 mol, polymerization may not proceed sufficiently. If the amount exceeds 50 mol, it may be difficult to purify the resulting polymer.

As examples of the palladium complex used as the component (a), dichlorobis(triphenylphosphine)palladium, dibromobis(triphenylphosphine)palladium, diiodobis(triphenylphosphine)palladium, dichlorobis(tri-o-tolylphosphine)palladium, dichlorobis(tricyanophenylphosphine)palladium, dichlorobis(tricyanomethylphosphine)palladium, dibromobis(tri-o-tolylphosphine)palladium, dibromobis(tricyanophenylphosphine)palladium, dibromobis(tricyanomethylphosphine)palladium, diiodobis(tri-o-tolylphosphine)palladium, diiodobis(tricyanophenylphosphine)palladium, diiodobis(tricyanomethylphosphine)palladium, tetrakis(triphenylphosphine)palladium, tetrakis(tri-o-tolylphosphine)palladium, tetrakis(tricyanophenylphosphine)palladium, tetrakis(tricyanomethylphosphine)palladium, and the like can be given. Of these, dichlorobis(triphenylphosphine)palladium and tetrakis(triphenylphosphine)palladium are preferable. These compounds may be used either individually or in combination of two or more. The palladium complex is used in an amount of usually 0.0001 to 10 mol, and preferably 0.001 to 1 mol for one mol of the total amount of the compounds shown by the general formulas (32) to (35). If the amount is less than 0.0001 mol, polymerization may not proceed sufficiently. If the amount exceeds 10 mol, it may be difficult to purify the resulting polymer.

As examples of the monovalent copper compound (b), copper(I) chloride , copper(I) bromide, copper(I) iodide, and the like can be given. These compounds may be used either individually or in combination of two or more. The monovalent copper compound (b) is used in an amount of usually 0.0001 to 10 mol, and preferably 0.001 to 1 mol for one mol of the total amount of the compounds shown by the general formulas (32) to (35). If the amount is less than 0.0001 mol, polymerization may not proceed sufficiently. If the amount exceeds 10 mol, it may be difficult to purify the resulting polymer.

As examples of the basic compound (c), pyridine, pyrrole, piperazine, pyrrolidine, piperidine, picoline, trimethylamine, triethylamine, monoethanolamine, diethanolamine, dimethylmonoethanolamine, monomethyldiethanolamine, triethanolamine, diazabicyclooctane, diazabicyclononane, diazabicycloundecene, tetramethylammonium hydroxide, diethylamine, ammonia, n-butylamine, imidazole, and the like can be given. Of these, diethylamine, piperidine, and n-butylamine are preferable. These compounds may be used either individually or in combination of two or more. The basic compound (c) is used in an amount of preferably 1 to 1000 mol, and still more preferably 1 to 100 mol for one mol of the total amount of the compounds shown by the general formulas (32) to (35). If the amount is less than 1 mol, polymerization may not proceed sufficiently. If the amount exceeds 100 mol, it may be uneconomical.

### 3.2.4 Compound 8

The polymer shown by the general formula (11) (hereinafter may be called "compound 8") may be produced by reacting a compound shown by the following general formula (36) and a compound shown by the following general formulas (37) and (38), for example.

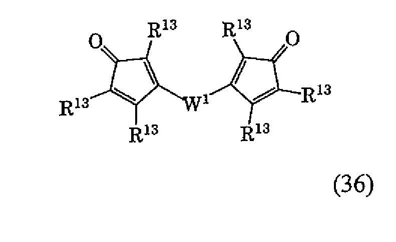

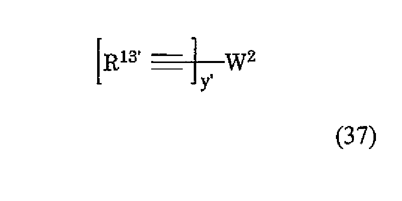

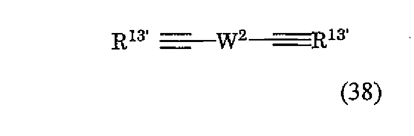

In the general formulas (36) to (38), R¹³ and R^{13'} represent a hydrogen atom or at least one group selected from the group consisting of the aromatic groups shown by the general formulas (12) and (13), and W¹ and W² represent at least one group selected from the group consisting of the divalent aromatic groups shown by the general formulas (14) and (15).

The compound 8 shown by the general formula (11) may be produced by subjecting the cyclopentadienone group shown by the general formula (36) and the acetylene group shown by the general formulas (37) and (38) to a Diels-Alder reaction.

The number average molecular weight (Mn) of the compound 8 is greater than 3,500, and preferably 4,000, and is less than preferably 6,400, and still more preferably 6,000. The weight average molecular weight (Mw) of the compound 8 is greater than 500, and preferably 8,000, and is less than preferably 15,000, and still more preferably 12,000. The compound 8 has a polydispersity (Mw/Mn) of preferably less than about 2.5, and still more preferably less than about 2.3.

### 3.2.5 Compound 9

The polymer shown by the general formula (16) (hereinafter called "compound 9") may be produced by reacting compounds shown by the following general formulas (39) to (41), for example. 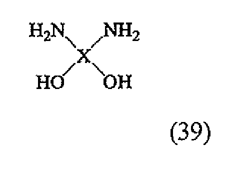 wherein X represents one structure selected from the structures shown by the formula (17).

HOOC-Y-COOH (40)

wherein Y represents one structure selected from the structures shown by the formula (18) or (19).

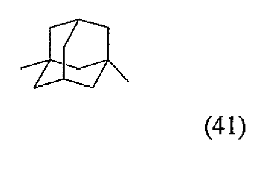

As examples of the compound shown by the general formula (39), 2,4-diaminoresorcinol, 4,6-diaminoresorcinol, 2,2-bis(3-amino-4-hydroxyphenyl)propane, 2,2-bis(4-amino-3-hydroxyphenyl)propane, 3,3'-diamino-4,4'-dihydroxybiphenylsulfone, 4,4'-diamino-3,3'-dihydroxybiphenylsulfone, 3,3'-diamino-4,4'-dihydroxybiphenyl, 4,4'-diamino-3,3'-dihydroxybiphenyl, 9,9-bis-{4-((4-amino-3-hydroxy)phenoxy)phenyl}fluorene, 9,9-bis-{4-((3-amino-4-hydroxy)phenoxy)phenyl}fluorene, 9,9-bis-{4-((4-amino-3-hydroxy)phenoxy-3-phenyl)phenyl} fluorene, 9,9-bis-{4-((3-amino-4-hydroxy)phenoxy-3-phenyl)phenyl}fluorene, 3,3'-diamino-4,4'-dihydroxydiphenyl ether, 4,4'-diamino-3,3'-dihydroxydiphenyl ether, and the like can be given. However, the invention is not limited thereto. These diaminophenol compounds may be used either individually or in combination of two or more.

As examples of the compound shown by the general formula (40), 4-methylisophthalic acid, 4-phenylisophthalic acid, 4-tert-butylisophthalic acid, 4-trimethylsilylisophthalic acid, 4-adamantylisophthalic acid, 5-methylisophthalic acid, 5-phenylisophthalic acid, 5-tert-butylisophthalic acid, 5-trimethylsilylisophthalic acid, 5-adamantylisophthalic acid, 2-methylterephthalic acid, 2-phenylterephthalic acid, 2-tert-butylterephthalic acid, 2-trimethylsilylterephthalic acid, 2-adamantylterephthalic acid, 4,4'-bis(2-methyl)phenyldicarboxylic acid, 4,4'-bis(3-methyl)phenyldicarboxylic acid, 4,4'-bis(2-tert-butyl)phenyldicarboxylic acid, 4,4'-bis(3-tert-butyl)phenyldicarboxylic acid, 4,4'-bis(2-trimethylsilyl)phenyldicarboxylic acid, 4,4'-bis(3-trimethylsilyl)phenyldicarboxylic acid, 4,4'-bis(2-adamantyl)phenyldicarboxylic acid, 4,4'-bis(3-adamantyl)phenyldicarboxylic acid, 6-methylnaphthalene-1,4-dicarboxylic acid, 6-tert-butylnaphthalene-1,4-dicarboxylic acid, 6-trimethylsilylnaphthalene-1,4-dicarboxylic acid, 6-adamantyl naphthalene-1,4-dicarboxylic acid, 4-methylnaphthalene-2,6-dicarboxylic acid, 4-tert-butylnaphthalene-2,6-dicarboxylic acid, 4-trimethylsilylnaphthalene-2,6-dicarboxylic acid, 4-adamantylnaphthalene-2,6-dicarboxylic acid, and the like can be given. However, the invention is not limited thereto. These compounds may be used in combination of two or more.

As examples of the dicarboxylic acid including the structure shown by the general formula (41) used in the invention, 1,3-adamantanedicarboxylic acid, 2,5-dimethyladamantane-1,3-dicarboxylic acid, 2,5-diphenyladamantane-1,3-dicarboxylic acid, 2,5-bis(t-butyl)adamantane-1,3-dicarboxylic acid, and the like can be given. However, the invention is not limited thereto. These compounds may be used in combination of two or more.

The compound 9 may be prepared by using a known acid chloride method, an active ester method, a synthesis method by a condensation reaction in the presence of a dehydration-condensation agent such as polyphosphoric acid or dicyclohexylcarbodiimide, or the like.

In the invention, it is preferable to react the diaminophenolic compound (M mol) shown by the general formula (39) and the dicarboxylic acid (N mol) shown by the general formula (40) at a molar ratio (N/M) of 0.5 to 0.9,9 to obtain a polymer having a branched structure. If the molar ratio (N/M) is greater than 0.9,9 the effect of decreasing the dielectric constant due to the bulky substituent of the dicarboxylic acid may be reduced. If the molar ratio (N/M) is smaller than 0.5, the molecular weight of the resulting polymer is not increased and an unreacted diaminophenol compound remains, whereby a problem may occur during deposition of the organic insulating film or a fragile organic insulating film may be obtained.

As an example of the polymerization method, the case of producing the polymer by using the acid chloride method is described below. For example, the dicarboxylic acid shown by the general formula (40), such as 5-tert-butylisophthalic acid, and excess thionyl chloride are reacted at room temperature or 75°C in the presence of a catalyst such as N,N-dimethylformamide. After evaporating the excess thionyl chloride by heating under reduced pressure, the residue is recrystallized from a solvent such as hexane to obtain 5-tert-butylisophthalic acid chloride. Then, the diaminophenol compound shown by the general formula (39), such as 2,2-bis(3-amino-4-hydroxyphenyl)propane is dissolved in a polar solvent such as N-methyl-2-pyrrolidone or N,N-dimethylacetamide, and the chloride compound of the dicarboxylic acid prepared in advance is reacted with the mixture at room temperature to -30°C in the presence of an acid acceptor such as triethylamine to obtain the compound 9 formed of the polymer having the polybenzoxazole precursor shown by the general formula (16) as the main structure.

The compound 9 may also be obtained by reacting an active ester compound of the dicarboxylic acid compound shown by the general formula (40) with the diaminophenol compound instead of the acid chloride compound.

A solvent may be used in the formation step of the film-forming composition for forming the organic insulating film of the invention, as required. There are no specific limitations to the polymerization solvent. As examples of the polymerization solvent, halogen solvents such as chloroform, dichloromethane, 1,2-dichloroethane, chlorobenzene, and dichlorobenzene; aromatic hydrocarbon solvents such as benzene, toluene, xylene, mesitylene, and diethyl benzene; ether solvents such as diethyl ether, tetrahydrofuran, dioxane, diglyme, anisole, diethylene glycol dimethyl ether, diethylene glycol diethyl ether, and diethylene glycol methyl ethyl ether; ketone solvents such as acetone, methyl ethyl ketone, 2-heptanone, cyclohexanone, and cyclopentanone; ester solvents such as methyl acetate, ethyl acetate, propyl acetate, butyl acetate, methyl lactate, ethyl lactate, butyl lactate, and γ-butyrolactone; amide solvents such as N,N-dimethylformamide, N,N-dimethylacetamide, and N-methyl-2-pyrrolidone; and the like can be given. It is preferable to use the solvent after sufficiently drying and deoxidizing the solvent. The solvent may be used either individually or in combination of two or more. The monomer (polymerization component) concentration in the polymerization solvent is preferably 1 to 80 wt%, and still more preferably 5 to 60 wt%. The polymerization temperature is preferably 0 to 150°C, and still more preferably 5 to 100°C. The polymerization time is preferably 0.5 to 100 hours, and still more preferably 1 to 40 hours.

In the invention, in order to form the organic insulating film, at least one polymer selected from the group consisting of the compounds 5 to 9 is dissolved in an organic solvent to obtain a composition 3. The composition 3 is applied to a substrate to form a coating, and the resulting coating is heated. The organic insulating film is obtained in this manner. As examples of the organic solvent used for the composition 3, aliphatic hydrocarbon solvents such as n-pentane, isopentane, n-hexane, isohexane, n-heptane, isoheptane, 2,2,4-trimethylpentane, n-octane, isooctane, cyclohexane, and methylcyclohexane; aromatic hydrocarbon solvents such as benzene, toluene, xylene, ethylbenzene, trimethylbenzene, methylethylbenzene, n-propylebenzene, isopropylebenzene, diethylbenzene, isobutylbenzene, triethylbenzene, diisopropylbenzene, n-amylnaphthalene, and trimethylbenzene; monohydric alcohol solvents such as methanol, ethanol, n-propanol, isopropanol, n-butanol, isobutanol, sec-butanol, t-butanol, n-pentanol, isopentanol, 2-methylbutanol, sec-pentanol, t-pentanol, 3-methoxybutanol, n-hexanol, 2-methylpentanol, sec-hexanol, 2-ethylbutanol, sec-heptanol, heptanol-3, n-octanol, 2-ethylhexanol, sec-octanol, n-nonyl alcohol, 2,6-dimethyl-heptanol-4, n-decanol, sec-undecyl alcohol, trimethylnonyl alcohol, sec-tetradecyl alcohol, sec-heptadecyl alcohol, phenol, cyclohexanol, methylcyclohexanol, 3,3,5-trimethylcyclohexanol, benzyl alcohol, phenylmethylcarbinol, and diacetone alcohol and cresol; polyhydric alcohol solvents such as ethylene glycol, 1,2-propylene glycol, 1,3-butylene glycol, pentanediol-2,4, 2-methyl-pentanediol-2,4, hexanediol-2,5, heptanediol-2,4, 2-ethyl-hexanediol-1,3, diethylene glycol, dipropylene glycol, triethylene glycol, tripropylene glycol, and glycerol; ketone solvents such as acetone, methyl ethyl ketone, methyl n-propyl ketone, methyl n-butyl ketone, diethyl ketone, methyl isobutyl ketone, methyl n-pentyl ketone, ethyl n-butyl ketone, methyl n-hexyl ketone, diisobutyl ketone, trimethylnonanone, cyclohexanone, cyclopentanone, 2-hexanone, methylcyclohexanone, 2,4-pentanedione, acetonylacetone, diacetone alcohol, acetophenone, and fenchone; ether solvents such as ethyl ether, isopropyl ether, n-butyl ether, n-hexyl ether, 2-ethylhexyl ether, ethylene oxide, 1,2-propylene oxide,-dioxolane, 4-methyl dioxolane, dioxane, dimethyl dioxane, ethylene glycol monomethyl ether, ethylene glycol monoethyl ether, ethylene glycol diethyl ether, ethylene glycol mono-n-butyl ether, ethylene glycol mono-n-hexyl ether, ethylene glycol monophenyl ether, ethylene glycol mono-2-ethyl butyl ether, ethylene glycol dibutyl ether, diethylene glycol monomethyl ether, diethylene glycol monoethyl ether, diethylene glycol diethyl ether, diethylene glycol mono-n-butyl ether, diethylene glycol di-n-butyl ether, diethylene glycol mono-n-hexyl ether, ethoxy triglycol, tetraethylene glycol di-n-butyl ether, propylene glycol monomethyl ether, propylene glycol monoethyl ether, propylene glycol monopropyl ether, propylene glycol monobutyl ether, dipropylene glycol monomethyl ether, dipropylene glycol monoethyl ether, tripropylene glycol monomethyl ether, tetrahydrofuran, and 2-methyltetrahydrofuran; ester solvents such as diethyl carbonate, methyl acetate, ethyl acetate, γ-butyrolactone, γ-valerolactone, n-propyl acetate, isopropyl acetate, n-butyl acetate, isobutyl acetate, sec-butyl acetate, n-pentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, n-nonyl acetate, methyl acetoacetate, ethyl acetoacetate, ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether acetate, propylene glycol monoethyl ether acetate, propylene glycol monopropyl ether acetate, propylene glycol monobutyl ether acetate, dipropylene glycol monomethyl ether acetate, dipropylene glycol monoethyl ether acetate, glycol diacetate, methoxy triglycol acetate, ethyl propionate, n-butyl propionate, isoamyl propionate, diethyl oxalate, di-n-butyl oxalate, methyl lactate, ethyl lactate, n-butyl lactate, n-amyl lactate, diethyl malonate, dimethyl phthalate, and diethyl phthalate; nitrogen-containing solvents such as N-methylformamide, N,N-dimethylformamide, N,N-dimethylformamide, acetamide, N-methylacetamide, N,N-dimethylacetamide, N-methylpropioneamide, and N-methylpyrrolidone; sulfur-containing solvents such as dimethyl sulfide, diethyl sulfide, thiophene, tetrahydrothiophene, dimethylsulfoxide, sulfolane, and 1,3-propanesultone; and the like can be given. These solvents may be used either individually or in combination of two or more.

The film-forming composition of the invention may further include components such as colloidal silica, organic polymer other than the compounds 5 to 9 used to form the organic insulating film, surfactant, silane coupling agent, radical generator, or compound containing a polymerizable double bond or polymerizable triple bond.

### 3.3 Method of depositing organic insulating film

The organic insulating film may be formed by applying the composition 1 to a substrate, removing the solvent, and curing the resulting coating by heating. As the method for applying the composition 1 to the substrate, a spin coating method, a dipping method, a roller blade method, and a spray method can be given. A coating with a thickness (dry thickness) of about 1 to 1000 nm is obtained by single application, and a coating with a thickness (dry thickness) of about 2 to 2000 nm is obtained by double application.

The coating may be dried by heating at about 60 to 600°C for about 1 to 240 minutes, for example. As the heating method, a hot plate, oven, furnace, or the like may be used. The coating may be heated in air, in nitrogen, in argon, under vacuum, or under reduced pressure in which the oxygen concentration is controlled. The coating may also be formed by applying electron beams or ultraviolet rays. In this case, the drying time can be reduced.

When forming the multilayer insulating film, the process time may be reduced by layering the polysiloxane layer, the polycarbosilane layer, and the organic film in a half-cured state, and curing the three layers at the same time.

### 4. Insulating film

The insulating film of the invention is obtained by the above-described method of forming an insulating film. Specifically, the insulating film of the invention is a multilayer insulating film in which at least the polycarbosilane insulating film, the polycarbosilane insulating film, and the organic insulating film are layered. In the insulating film, the polycarbosilane insulating film is provided between the polysiloxane insulating film (low-k film) and the organic insulating film. The polycarbosilane insulating film is damaged by etching to only a small extent even when exposed to a treatment atmosphere for etching such as RIE. Therefore, the polysiloxane insulating film provided under the organic insulating film is not damaged by etching. Therefore, the insulating film of the invention exhibits excellent resistance against processing such as etching, ashing, or wet cleaning while maintaining the low relative dielectric constant of the polysiloxane insulating film.

The insulating film of the invention is particularly advantageous for a semiconductor device including an interconnect layer having a dual-damascene structure, in which the polysiloxane insulating film is used as a layer in which a via is formed and the organic insulating film is used as a layer in which a trench is formed. In this case, the organic insulating film is etched to form the trench. However, etching damage may occur in the polysiloxane insulating film in the lower layer during etching. According to the invention, since the polycarbosilane insulating film is provided between the organic insulating film and the polysiloxane insulating film, the polysiloxane insulating film can be protected. Therefore, according to the insulating film of the invention, a semiconductor device having an interconnect layer with higher reliability can be provided.

The insulating film of the invention is useful for applications such as an interlayer dielectric for semiconductor devices such as an LSI, system LSI, DRAM, SDRAM, RDRAM, and D-RDRAM, a protective film such as a surface coating film for semiconductor devices, an interlayer dielectric for multilayer interconnect substrates, and a protective film and an insulating film for liquid crystal display elements.

### 5. Example

The invention is described below in more detail by way of examples. In the examples and comparative examples, "part" and "%" respectively indicate "part by weight" and "wt%" unless otherwise indicated. The following description generally represents aspects of the invention, and should not be construed as limiting the invention.

### 5.1 Preparation of polycarbosilane solution

### 5.1.1 Preparation Example 1

Polycarbosilane ("NIPUSI Type-s" available from Nippon Carbon Co., Ltd.; carbosilane polymer of polydimethylsilane) was dissolved in a mixed solution of propylene glycol monopropyl ether and cyclohexanone (weight ratio: propylene glycol monopropyl ether:cyclohexanone = 50:50) so that the solid content was 2% to obtain a film-forming composition (A).

### 5.1.2 Preparation Example 2

Polyallyldihydrocarbosilane ("SP-10" available from Starfire; carbosilane polymer of polydimethylsilane) was dissolved in a mixed solution of propylene glycol monopropyl ether and 2-heptanone (weight ratio: propylene glycol monopropyl ether:cyclohexanone = 50:50) so that the solid content was 2% to obtain a film-forming composition (B).

### 5.2 Formation of insulating film

### 5.2.1 Example 1

A polysiloxane compound was obtained by the following method. A separable flask made of quartz was charged with 570 g of distilled ethanol, 160 g of ion-exchanged water, and 30 g of a 10% tetramethylammonium hydroxide aqueous solution. The mixture was then uniformly stirred. A mixture of 136 g of methyltrimethoxysilane and 209 g of tetraethoxysilane was added to the solution. The mixture was then allowed to react for two hours while maintaining the solution at 55°C. After the addition of 300 g of propylene glycol monopropyl ether to the solution, the mixture was concentrated at 50°C by using an evaporator until the solid content was 10% (converted into complete hydrolysis-condensation product). Then, 10 g of a 10% propylene glycol monopropyl ether solution of acetic acid was added to obtain a coating liquid. The coating liquid was filtered through a Teflon (registered trademark) filter with a pore size of 0.2 µm to obtain a polysiloxane compound film-forming composition (C).

The film-forming composition (C) was applied to an 8-inch silicon wafer by spin coating and sintered at 400°C to obtain a polysiloxane insulating film (low-k film) (thickness: 400 nm, dielectric constant: 2.3).

The film-forming composition (A) was applied to the polysiloxane insulating film by spin coating, and dried at 80°C for one minute and at 200°C for one minute to form a polycarbosilane insulating film (protective layer) (thickness: 10 nm).

An organic insulating film was then formed on the polycarbosilane insulating film. Before forming the organic insulating film, a film-forming composition (D) for forming the organic insulating film was prepared by the following method.

A 1,000 ml three-necked flask equipped with a thermometer, an argon gas feed pipe, and a stirrer was charged with 120 ml of tetrahydrofuran, 3.46 g of tetrakistriphenylphosphine palladium, 2.1 g of dichlorobistriphenylphosphine palladium, 1,4,4 g of copper iodide, 20 ml of piperidine, and 185.72 g of 4,4'-bis(2-iodophenoxy)benzophenone. After the addition of 65.48 g of 4,4'-diethynyldiphenyl ether, the mixture was allowed to react at 25°C for 20 hours. The reaction solution was reprecipitated twice from 5 1 of acetic acid. The resulting precipitate was dissolved in cyclohexanone and washed twice with ultrapure water. The resulting solution was reprecipitated twice from 5 1 of acetic acid. The resulting precipitate was filtered and dried to obtain a polymer having a weight average molecular weight of 35,000. 20 g of the polymer was dissolved in 180 g of cyclohexanone to obtain the film-forming composition solution (D).

The weight average molecular weight (Mw) of the polymer was measured by the gel permeation chromatography (GPC) method under the following conditions. Sample: A sample was prepared by dissolving 1 g of the polymer in 100 cc of tetrahydrofuran used as a solvent. Standard polystyrene: Standard polystyrene manufactured by Pressure Chemical of the U.S. was used.
Device: High-temperature high-speed gel permeation chromatogram (Model 150-C ALC/GPC) manufactured by Waters of the U.S.
Column: SHODEX A-80M (length: 50 cm) manufactured by Showa Denko K.K.
Measurement temperature: 40°C
Flow rate:

The film-forming composition (D) was applied to the polycarbosilane insulating film by using a spin coating method. The applied composition was sintered at 400°C for one hour to form the organic insulating film.

An insulating film of Example 1 (laminate of three layers of insulating films) was obtained in this manner.

### 5.2.2 Example 2

The film-forming composition (C) obtained in Example 1 was applied to an 8-inch silicon wafer by spin coating and dried at 80°C for one minute and at 200°C for one minute to obtain an uncured polysiloxane insulating film (thickness: 400 nm).

The film-forming composition (A) was applied to the uncured polysiloxane insulating film by spin coating, and dried at 80°C for one minute and at 200°C for one minute to form a polycarbosilane insulating film (protective layer) (thickness: 10 nm).

The film-forming composition (D) was then applied to the polycarbosilane insulating film by using a spin coating method. The applied composition was sintered at 400°C for one hour to form an organic insulating film.

An insulating film of Example 2 (laminate of three layers of insulating films) was obtained in this manner.

### 5.2.3 Example 3

The film-forming composition (C) obtained in Example 1 was applied to an 8-inch silicon wafer by spin coating and dried at 80°C for one minute and at 200°C for one minute to obtain an uncured polysiloxane insulating film (thickness: 400 nm).

The film-forming composition (B) was applied to the uncured polysiloxane insulating film by spin coating, and dried at 80°C for one minute and at 200°C for one minute to form a polycarbosilane insulating film (protective layer) (thickness: 10 nm).

The film-forming composition (D) was then applied to the polycarbosilane insulating film by using a spin coating method. The applied composition was sintered at 400°C for one hour to form an organic insulating film.

An insulating film of Example 3 (laminate of three layers of insulating films) was obtained in this manner.

### 5.2.4 Comparative Example 1

The film-forming composition (C) obtained in Example 1 was applied to an 8-inch silicon wafer by spin coating and sintered at 400°C to obtain a polysiloxane insulating film (thickness: 400 nm, dielectric constant: 2.3).

The film-forming composition (D) was then applied to the polysiloxane insulating film by using a spin coating method. The applied composition was sintered at 400°C for one hour to form an organic insulating film. In Comparative Example 1, an insulating film formed of two insulating layers was obtained without forming a polycarbosilane insulating film as a protective layer.

### 5.3 Evaluation of insulating film

### 5.3.1 Measurement of relative dielectric constant

A relative dielectric constant measurement sample was prepared by forming an aluminum electrode pattern on the resulting insulating film by using a deposition method. The relative dielectric constant of each sample was measured by a CV method at a frequency of 100 kHz using an electrode "HP16451B" and a precision LCR meter "HP4284A" manufactured by Yokogawa-Hewlett-Packard, Ltd. The measurement results are shown in Table 1.

### 5.3.2 Evaluation of film thickness

The thickness of each layer of the insulating film formed of the laminate was calculated by using a multilayer analysis mode of "n&k analyzer 1500" manufactured by N&K technology Inc. The thickness of each layer thus calculated was used when calculating the relative dielectric constant in 5.2.3.

### 5.3.3 Extraction of relative dielectric constant of polysiloxane insulating film

The relative dielectric constant of the organic insulating film separately deposited on a silicon wafer was measured, and the organic insulating film was assumed to have this relative dielectric constant after layering. The relative dielectric constant of the polysiloxane insulating film was calculated by utilizing this relative dielectric constant using a series capacitor model from the measurement results for the thickness of each layer obtained by the multilayer analysis and the relative dielectric constant of the laminate. The measurement results are shown in Table 1.

### 5.3.4 Chemical resistance (process resistance) of film

The wafer laminates obtained in Examples 1 to 3 and Comparative Example 1 were cut to a size of 2×10 mm to prepare samples. Each sample was immersed in a 0.2% diluted hydrofluoric acid aqueous solution at room temperature. The fracture plane of the sample was observed by using an SEM to determine whether or not the polysiloxane insulating film was etched by the diluted hydrofluoric acid. The measurement results are shown in Table 1.

### 5.3.5 Evaluation of RIE resistance

The insulating films obtained in Examples 1 to 3 and Comparative Example 1 were sintered at 400°C for one hour in a nitrogen atmosphere. Each multilayer film was exposed to an organic low-k film etching condition using ammonia or oxygen by using a plasma etching device manufactured by Tokyo Electron Ltd. to evaluate the RIE resistance from a change in the dielectric constant of the siloxane low-k film before and after exposure. The measurement results of the dielectric constant of the polysiloxane insulating film before and after exposure are shown in Table 1.

### 5.3.6 Measurement of fracture toughness

The adhesive strength at the interface between the polysiloxane insulating film and the organic insulating film of the insulating film obtained in each of Examples 1 to 3 and Comparative Example 1 was measured by using a four-point bending method. The measurement results are shown in Table 2.

**TABLE 1**

| | Etching gas | Relative dielectric constant of polysiloxane insulating film | Etching damage due to diluted hydrofluoric acid |
|---|---|---|---|
| Example 1 | None | 2.29 | None |
| Example 1 | Ammonia | 2.33 | None |
| Example 1 | Oxygen | 2.35 | None |
| Example 2 | None | 2.3 | None |
| Example 2 | Ammonia | 2.37 | None |
| Example 2 | Oxygen | 2.4 | None |
| Example 3 | None | 2.31 | None |
| Example 3 | Ammonia | 2.36 | None |
| Example 3 | Oxygen | 2.38 | None |
| Comparative Example 1 | None | 2.27 | Occurred |
| Comparative Example 1 | Ammonia | 2.89 | Occurred |
| Comparative Example 1 | Oxygen | 3.56 | None |

**TABLE2**

| | Fracture toughness (J/m²) |
|---|---|
| Example 1 | 6 |
| Example 2 | 8.7 |
| Example 3 | 10.5 |
| Comparative Example 1 | 4.8 |

In the insulating films of Examples 1 to 3, the polycarbosilane insulating film is formed on the polysiloxane insulating film, and the polycarbosilane insulating film functions as a protective layer for the polysiloxane insulating film. Therefore, in the insulating films of Examples 1 to 3, in which the polycarbosilane insulating film was formed on the polysiloxane insulating film, an increase in the relative dielectric constant and occurrence of etching due to the hydrofluoric acid were not observed. Therefore, according to the insulating films of Examples 1 to 3, it was confirmed that damage (damage caused by plasma used for etching) occurring when etching the organic insulating film formed on the polysiloxane insulating film can be reduced.

On the other hand, since the polycarbosilane insulating film is not formed in the insulating film of Comparative Example 1, it was confirmed that damage due to etching occurs and the relative dielectric constant is increased, as shown in Table 1.

As shown in Table 2, it was confirmed that the insulating films of Examples 1 to 3 exhibit excellent fracture toughness and improved adhesive strength in comparison with the insulating film of Comparative Example 1.

## Claims

1. A method of forming an insulating film, the method comprising:
forming a polysiloxane insulating film on a substrate;
forming a polycarbosilane insulating film on the polysiloxane insulating film; and
forming an organic insulating film on the polycarbosilane insulating film;
wherein the polysiloxane insulating film is formed by hydrolysis and condensation of at least one silane compound selected from the group consisting of compounds shown by the following general formulas (1) to (3),
RₐSi(OR¹)₄₋ₐ (1)
wherein R represents a hydrogen atom, a fluorine atom, or a monovalent organic group, R¹ represents a monovalent organic group, and a represents an integer of 1 or 2,
Si(OR²)₄ (2)
wherein R² represents a monovalent organic group,
R³_{b}(R⁴O)_{3-b}Si-(R⁷)_{d}-Si(OR⁵)_{3-c}R⁶_{c} (3)
wherein R³ to R⁶ individually represent monovalent organic groups, b and c individually represent an integer from 0 to 2, R⁷ represents an oxygen atom, a phenylene group, or a group -(CH₂)ₘ- (wherein m represents an integer from 1 to 6), and d represents 0 or 1; and
wherein the polycarbosilane insulating film is formed by applying a solution, obtained by dissolving a polycarbosilane compound shown by the following general formula (4) in a solvent, to the polysiloxane insulating film, and heating the resulting coating, 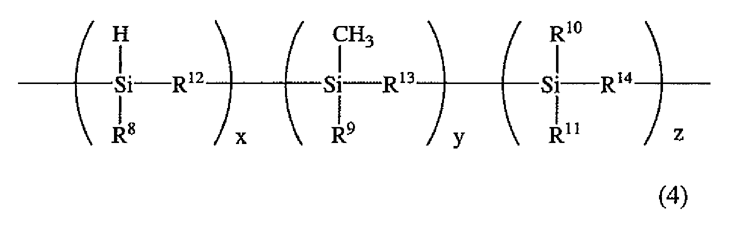 wherein R⁸ to R¹¹ individually represent a hydrogen atom, a halogen atom, a hydroxyl group, alkoxyl group, sulfone group, methanesulfone group, trifluoromethanesulfone group, or monovalent organic group, R¹² to R¹⁴ individually represent a substituted or unsubstituted alkylene group, alkenyl group, alkynyl group, or arylene group, and x, y, and z represent integers from 0 to 10,000, provided that x, y, and z satisfy a condition of "10 < x+y+z < 20,000".

2. The method of forming an insulating film according to claim 1,
wherein the organic insulating film is formed by applying a solution, obtained by dissolving or dispersing at least one polymer selected from polymers having a polyarylene skeleton, polyarylene ether skeleton, polyoxazoline skeleton, or polybenzocyclobutene skeleton in a solvent, to the polycarbosilane insulating film, and heating the resulting coating.

3. An insulating film comprising:
a polysiloxane insulating film formed on a substrate;
a polycarbosilane insulating film formed on the polysiloxane insulating film; and
an organic insulating film formed on the polycarbosilane insulating film;
wherein the polysiloxane insulating film is formed by hydrolysis and condensation of at least one silane compound selected from the group consisting of compounds shown by the following general formulas (1) to (3),
RₐSi(OR¹)₄₋ₐ (1)
wherein R represents a hydrogen atom, a fluorine atom, or a monovalent organic group, R¹ represents a monovalent organic group, and a represents an integer of 1 or 2,
Si(OR²)₄ (2)
wherein R² represents a monovalent organic group,
R³_{b}(R⁴O)_{3-b}Si-(R⁷)_{d}-Si(OR⁵)_{3-c}R⁶_{c} (3)
wherein R³ to R⁶ individually represent monovalent organic groups, b and c individually represent an integer from 0 to 2, R⁷ represents an oxygen atom, a phenylene group, or a group -(CH₂)ₘ- (wherein m represents an integer from 1 to 6), and d represents 0 or 1; and
wherein the polycarbosilane insulating film is formed by applying a solution, obtained by dissolving a polycarbosilane compound shown by the following general formula (4) in a solvent, to the polysiloxane insulating film, and heating the resulting coating, 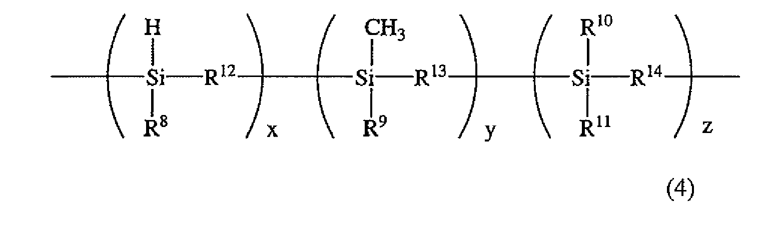 wherein R⁸ to R¹¹ individually represent a hydrogen atom, a halogen atom, a hydroxyl group, alkoxyl group, sulfone group, methanesulfone group, trifluoromethanesulfone group, or monovalent organic group, R¹² to R¹⁴ individually represent a substituted or unsubstituted alkylene group, alkenyl group, alkynyl group, or arylene group, and x, y, and z represent integers from 0 to 10,000, provided that x, y, and z satisfy a condition of "10 < x+y+z < 20,000".

4. The insulating film according to claim 3,
wherein the organic insulating film is formed by applying a solution, obtained by dissolving or dispersing at least one of a polyarylene, polyarylene ether, polyoxazoline, or polybenzocyclobutene in a solvent, to the polycarbosilane insulating film, and heating the resulting coating.

5. A film-forming composition for forming a polycarbosilane insulating film used in the method according to claim 1 or 2, the composition comprising:
a solution prepared by dissolving a polycarbosilane compound shown by the following general formula (4) in a solvent, 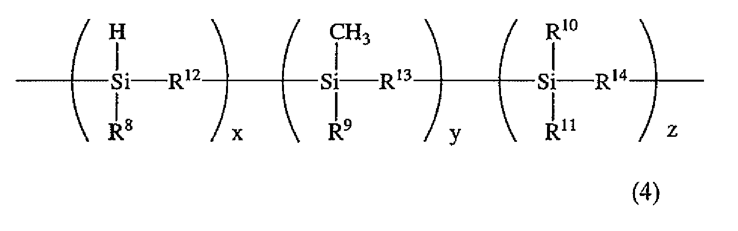
wherein R⁸ to R¹¹ individually represent a hydrogen atom, a halogen atom, a hydroxyl group, alkoxyl group, sulfone group, methanesulfone group, trifluoromethanesulfone group, or monovalent organic group, R¹² to R¹⁴ individually represent a substituted or unsubstituted alkylene group, alkenyl group, alkynyl group, or arylene group, and x, y, and z represent integers from 0 to 10,000, provided that x, y, and z satisfy a condition of "10 < x+y+z < 20,000".

## Amended claims

### Amended claims under Art. 19.1 PCT

1. A method of forming an insulating film, the method comprising:
forming a polysiloxane insulating film on a substrate;
forming a polycarbosilane insulating film on the polysiloxane insulating film; and
forming an organic insulating film on the polycarbosilane insulating film;
wherein the polysiloxane insulating film is formed by hydrolysis and condensation of at least one silane compound selected from the group consisting of compounds shown by the following general formulas (1) to (3),
RₐSi(OR¹)₄₋ₐ (1)
wherein R represents a hydrogen atom, a fluorine atom, or a monovalent organic group, R¹ represents a monovalent organic group, and a represents an integer of 1 or 2,
Si(OR²)₄ (2)
wherein R² represents a monovalent organic group,
R³_{b}(R⁴O)_{3-b}Si-(R⁷)_{d}-Si(OR⁵)_{3-c}R⁶_{c} (3)
wherein R³ to R⁶ individually represent monovalent organic groups, b and c individually represent an integer from 0 to 2, R⁷ represents an oxygen atom, a phenylene group, or a group -(CH₂)ₘ- (wherein m represents an integer from 1 to 6), and d represents 0 or 1; and
wherein the polycarbosilane insulating film is formed by applying a solution, obtained by dissolving a polycarbosilane compound shown by the following general formula (4) in a solvent, to the polysiloxane insulating film, and heating the resulting coating, 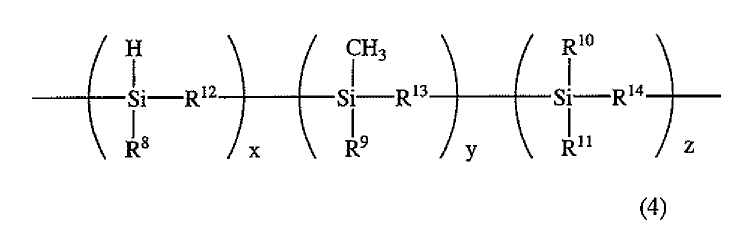 wherein R⁸ to R¹¹ individually represent a hydrogen atom, a halogen atom, a hydroxyl group, alkoxyl group, sulfone group, methanesulfone group, trifluoromethanesulfone group, or monovalent organic group, R¹² to R¹⁴ individually represent a substituted or unsubstituted alkylene group, alkenyl group, alkynyl group, or arylene group, and x, y, and z represent integers from 0 to 10,000, provided that x, y, and z satisfy a condition of "10 < x+y+z < 20,000".

2. The method of forming an insulating film according to claim 1,
wherein the organic insulating film is formed by applying a solution, obtained by dissolving or dispersing at least one polymer selected from polymers having a polyarylene skeleton, polyarylene ether skeleton, polyoxazoline skeleton, or polybenzocyclobutene skeleton in a solvent, to the polycarbosilane insulating film, and heating the resulting coating.

3. An insulating film comprising:
a polysiloxane insulating film formed on a substrate;
a polycarbosilane insulating film formed on the polysiloxane insulating film; and
an organic insulating film formed on the polycarbosilane insulating film;
wherein the polysiloxane insulating film is formed by hydrolysis and condensation of at least one silane compound selected from the group consisting of compounds shown by the following general formulas (1) to (3),
RₐSi(OR¹)₄₋ₐ (1)
wherein R represents a hydrogen atom, a fluorine atom, or a monovalent organic group, R¹ represents a monovalent organic group, and a represents an integer of 1 or 2,
Si(OR²)₄ (2)
wherein R² represents a monovalent organic group,
R³_{b}(R⁴O)_{3-b}Si-(R⁷)_{d}-Si(OR⁵)_{3-c}R⁶_{c} (3)
wherein R³ to R⁶ individually represent monovalent organic groups, b and c individually represent an integer from 0 to 2, R⁷ represents an oxygen atom, a phenylene group, or a group -(CH₂)ₘ- (wherein m represents an integer from 1 to 6), and d represents 0 or 1; and
wherein the polycarbosilane insulating film is formed by applying a solution, obtained by dissolving a polycarbosilane compound shown by the following general formula (4) in a solvent, to the polysiloxane insulating film, and heating the resulting coating, 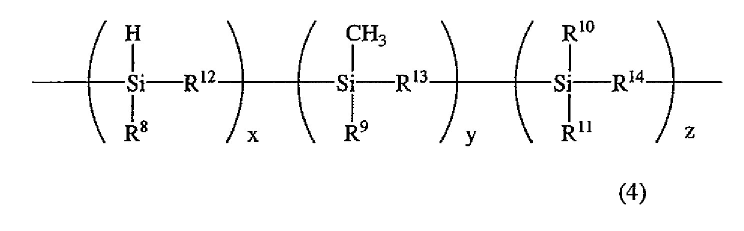 wherein R⁸ to R¹¹ individually represent a hydrogen atom, a halogen atom, a hydroxyl group, alkoxyl group, sulfone group, methanesulfone group, trifluoromethanesulfone group, or monovalent organic group, R¹² to R¹⁴ individually represent a substituted or unsubstituted alkylene group, alkenyl group, alkynyl group, or arylene group, and x, y, and z represent integers from 0 to 10,000, provided that x, y, and z satisfy a condition of "10 < x+y+z < 20,000".

4. The insulating film according to claim 3,
wherein the organic insulating film is formed by applying a solution, obtained by dissolving or dispersing at least one of a polyarylene, polyarylene ether, polyoxazoline, or polybenzocyclobutene in a solvent, to the polycarbosilane insulating film, and heating the resulting coating.
